Europäisches Patentamt

European Patent Office

Office européen des brevets

(19)

(11) EP 0 413 831 B1

(12) **EUROPEAN PATENT SPECIFICATION**

(45) Date of publication and mention
of the grant of the patent:
**16.06.1999 Bulletin 1999/24**

(21) Application number: **90904428.1**

(22) Date of filing: **09.03.1990**

(51) Int Cl.⁶: **G06F 17/50**

(86) International application number:
**PCT/JP90/00315**

(87) International publication number:
**WO 90/10914 (20.09.1990 Gazette 1990/22)**

(54) **METHOD OF OPTIMISING LOGIC CIRCUIT**

OPTIMIERUNGSVERFAHREN EINER LOGISCHEN SCHALTUNG

METHODE D'OPTIMISATION D'UN CIRCUIT LOGIQUE

(84) Designated Contracting States:
**DE FR GB**

(30) Priority: **09.03.1989 JP 5690689**

(43) Date of publication of application:
**27.02.1991 Bulletin 1991/09**

(73) Proprietor: **FUJITSU LIMITED**
**Kawasaki-shi, Kanagawa 211 (JP)**

(72) Inventors:
• **MATSUNAGA, Yusuke**
**Yokohama-shi, Kanagawa 233 (JP)**
• **FUJITA, Masahiro**
**Kawasaki-shi, Kanagawa 214 (JP)**

(74) Representative:
**Fane, Christopher Robin King et al**
**Haseltine Lake & Co.,**
**Imperial House,**
**15-19 Kingsway**
**London WC2B 6UD (GB)**

(56) References cited:
JP-A- 62 194 578       JP-A- 63 085 976
JP-A- 63 129 645

• **IEEE INTERNATIONAL CONFERENCE ON COMPUTER-AIDED DESIGN NOVEMBER 7-10 1988 SANTA CLARA CA US pages 2 - 5 FUJITA ET AL 'evaluation and improvements of boolean comparison method based on binary decision diagrams'**
• **IEEE TRANSACTIONS ON COMPUTERS vol. C 35, no. 8, August 1986, pages 677 - 691 BRYANT 'graph-based algorithms for boolean function manipulation'**
• **PROCEEDINGS IEEE INTERNATIONAL CONFERENCE ON COMPUTERS DESIGN : VLSI IN COMPUTERS OCTOBER 6-9 1986 NEW YORK US pages 552 - 557 BARLETT ET AL 'multi-level logic minimization using implicit don't cares'**
• **IEEE INTERNATIONAL CONFERENCE ON COMPUTER-AIDED DESIGN NOVEMBER 5-9 1989 SANTA CLARA CA US pages 556 - 559 MATSUNAGA ET AL 'multi-level logic optimization using binary decision diagrams'**

## Description

The present invention relates to optimising logic circuits so as to convert a multistage logic circuit comprising a plurality of logic gates to a smaller scale logic circuit without changing its output logic.

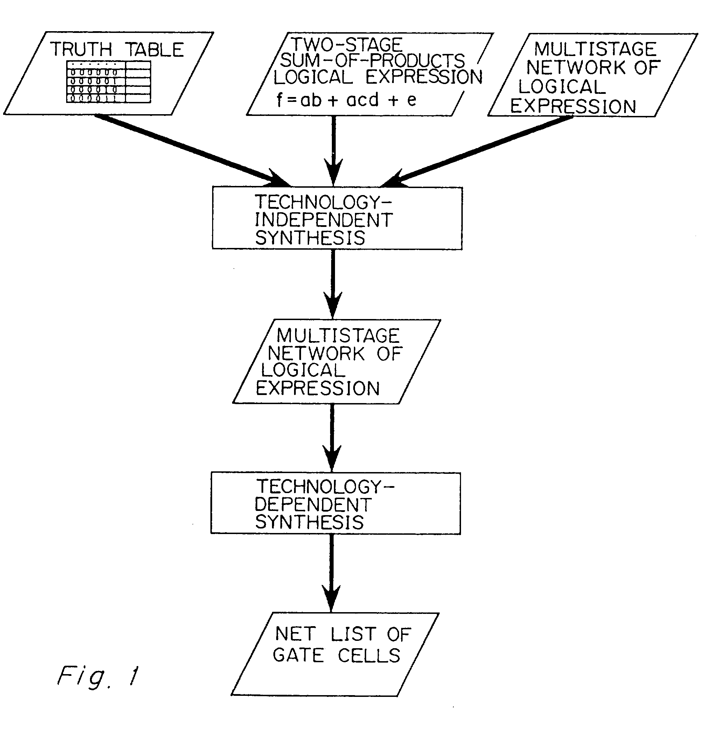

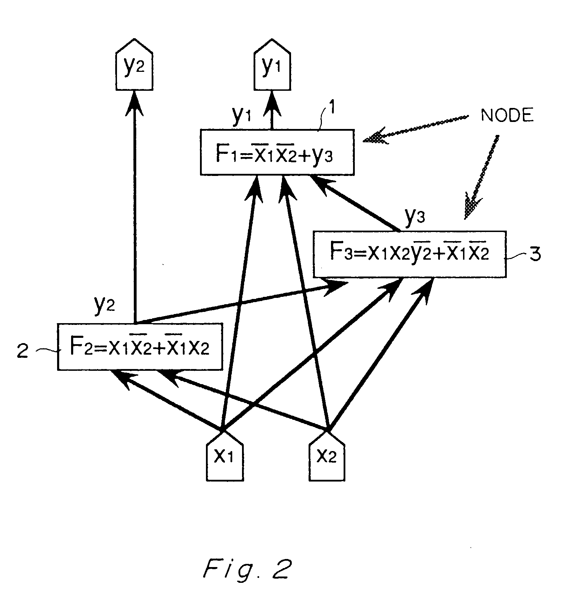

The general flow of a logic synthesizing process is illustrated in Figure 1. The inputs may be applied in the form of a truth table representing a logical function of an object circuit, a logical expression in a two-stage sum-of-products form or a logical expression in a multistage network form (as shown in Figure 2, each portion in the network that corresponds to one logical expression is called a node) in which truth tables or logical expressions for respective stages are combined. The final output is provided in the form of a net list of gate cells depending on a gate-array or standard-cell technology.

Figure 2 illustrates an example of the multistage network of logical expressions in Figure 1. More specifically, Figure 2 illustrates a multistage logic circuit with inputs $x_1$, $x_2$ and outputs $y_1$, $y_2$. Each of three nodes 1, 2 and 3 corresponds to one logical expression.

Various internal processing systems have been proposed for a logic synthesizing process such as that shown in Figure 1. In general, the system is divided into a portion, such as that shown in Figure 2, adapted to create a multistage network of technology-independent logical expressions and a portion adapted to convert the network to actual circuits. Hereinafter, the technology-independent process will be mainly described.

In the technology-independent process, a given logical expression is converted to a simpler logical expression (the term "simple" means that the number of factors used in a logical expression is small). A common part is factored out from the logical expression, thereby creating a desired multistage logic network (which is called a logic synthesis or a logic optimizing process).

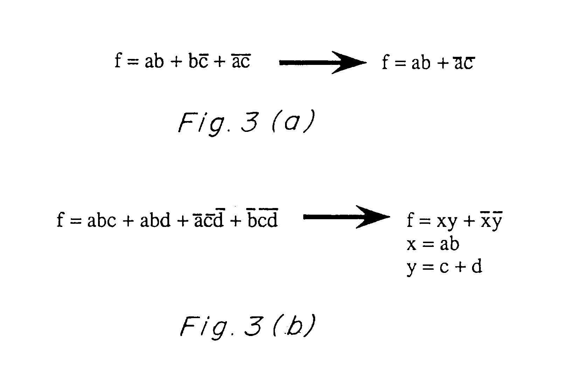

Figures 3(a) and 3(b) illustrate examples of the logic optimizing process. More specifically, Figure 3(a) illustrates an example of a simplification in which $f = ab + b\bar{c} + \bar{a}\bar{c}$ is simplified such that

$$f = abc + ab\bar{c} + a\bar{b}\bar{c} + \bar{a}b\bar{c} + \bar{a}\bar{b}\bar{c} + \bar{a}\bar{b}\bar{c}$$

$$= abc + ab\bar{c} + \bar{a}b\bar{c} + \bar{a}\bar{b}\bar{c}$$

$$= ab + \bar{a}\bar{c}$$

In the case of Figure 3(b), ab and c + d, which appear repeatedly, are replaced with new variables x and y, respectively, and common parts are factored out.

Such processes are all performed by changing the expressions on a symbolic manipulation basis. Since those expressions are Boolean algebraic expressions, the simplification and factoring should be defined in accordance with Boolean algebra. However, changing expressions based on Boolean algebra is very costly (with respect to calculation time and memories used), and the processes as shown in Figure 3 also cause a lot of trouble in calculation in proportion to the exponents of the input variables in the worst case. For high-speed processes, therefore, these expressions may be regarded as normal algebraic expressions. Of course, normal algebraic expressions and Boolean algebraic expressions have no identical property. For instance, a + a = a and aa = a in Boolean algebra, while, according to normal algebraic expressions, $a + a = 2a$ and $aa = a^2$. Thus, when f = ad + bcd + e and g = a + b, f can be expressed as f = gd(a + c) + e in the Boolean algebra. But, f cannot be expressed by use of g in normal algebra. Also, since a certain variable and its negation cannot be recognized, conversion utilizing the theorem of $a + \bar{a} = 1$ cannot be performed. Having such drawbacks, a circuit automatically synthesized by use of only processes based on normal algebra is inferior, in circuit scale, to a circuit resulting from automatic synthesis using the rules of Boolean algebra.

Several methods of performing Boolean algebraic processes have been proposed in order to create high-quality circuits. One of them is a method based on simplification of a two-stage sum-of-products logical expression (hereinafter referred to as method A), according to which the "don't care condition" for each node in a network is utilized for simplification of the node and factoring. There is a case in which a particular combination of node values never occurs in a multistage network and a case where output node values do not affect values at the external output terminal. Thus, the "don't care conditions" for each node are expressed in the form of a sum-of-products logical expression using external inputs and intermediate nodes. Even if the logic function of the node is changed due to some transformation of the expression, when the "don't care conditions" involve the case in which a change occurs, the transformation will not alter the logic function of the entire circuit (a combination of such values cannot occur or the effect of such change does not arrive at the output). Thus, the use of the "don't care conditions" will permit more powerful simplification and factoring.

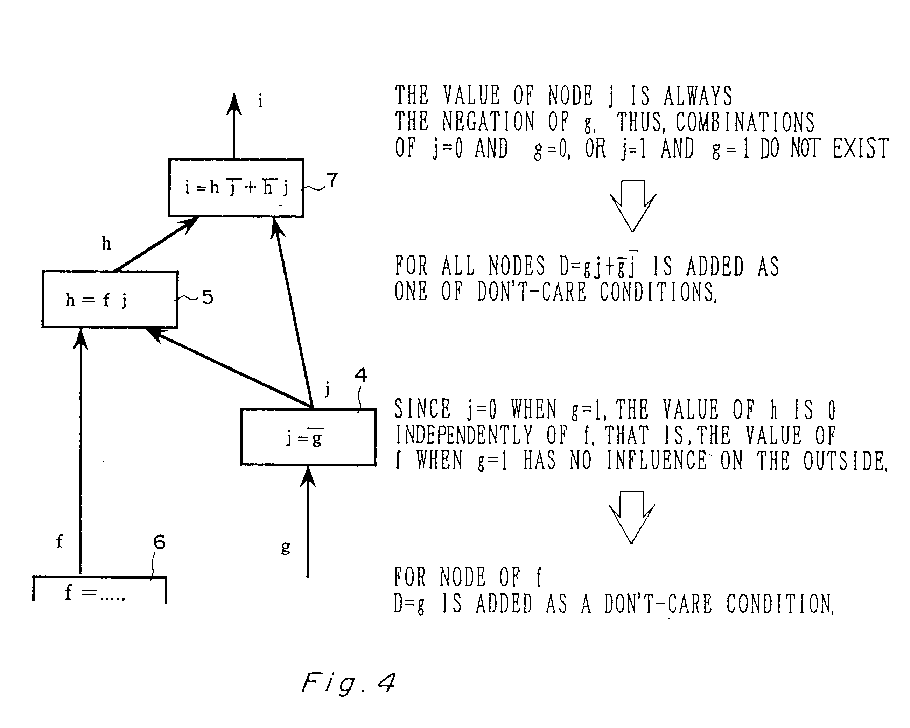

Figure 4 illustrates an example of the "don't care conditions" of the method A. In the Figure, since, for example, at node 4, its output j is the inverse signal of an input g, combinations of j = 0, g = 0; and j = 1, g = 0 cannot occur. Thus,

$D = \bar{g} \cdot \bar{j} + g \cdot j$ becomes effective as the don't-care condition for all the nodes.

The time required for calculation in the method is proportional to the square of the number of product terms (in the case of a + bc, a and bc are product terms) in a logical expression involving a don't-care condition. Thus, high-speed processing will be made possible if a compact expression using a sum-of-products logical expression is allowed. Since the number of product terms in a sum-of-products logical expression representing don't-care conditions in a normal multistage logic network is very large, a device for reducing the number of product terms representing don't care has been proposed in order to perform a process within a practical period (of course, the capability decreases as compared with the case where a complete don't-care conditions is used).

According to another method, an actual logic function and a don't-care condition of a node are defined as a vector (the so-called a truth table) for a set of values of external inputs (hereinafter referred to as method B).

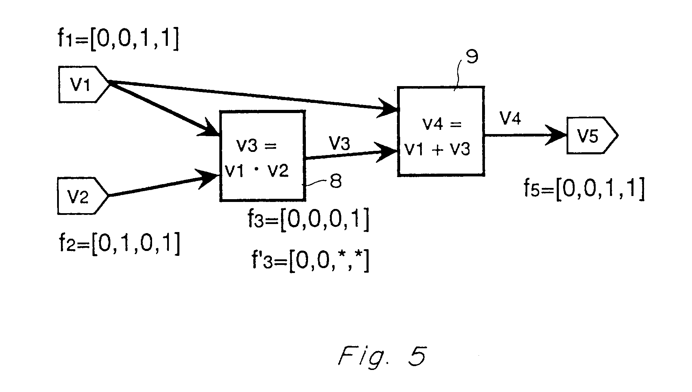

Figure 5 illustrates an example of don't-care conditions in method B. In this example, a $V_1$ and $V_2$ are input and $V_5$ is output. For example,

$$f_5 = [0, 0, 1, 1]$$

represents that the output $V_5$ changes in the order of 0, 0, 1, 1 when the input $V_1$ changes in the order of 0, 0, 1, 1, while the input $V_2$ changes in the order of 0, 1, 0, 1.

In Figure 5, it is the logical values of the output $V_5$ (which is herein the same as that of $V_4$) that the logic circuit needs to provide for different logical values of the inputs $V_1$ and $V_2$. There is no need for the logical value of the node 8 to be output. Thus, gates internal to the circuit (the node 8 in this case) can be permitted to take any suitable logical values provided that the logical value of the output $V_5$ remains unchanged. The output of gate 8 in such a case can be represented by a permissible function. That is, for the node 9, since $V_3 = 1$ is permissible (i.e. does not affect the output variable $V_5$) when $V_1 = 1$ and $V_2 = 0$, and $V_3 = 0$ is also permissible when $V_1 = V_2 = 1$,

$$f_3 = [0, 0, 1, 0]$$

can be written. Thus, the permissible function for the logic of the output $V_3$ of the node 8 can be written as (0, 0, *, *). * stands for don't care.

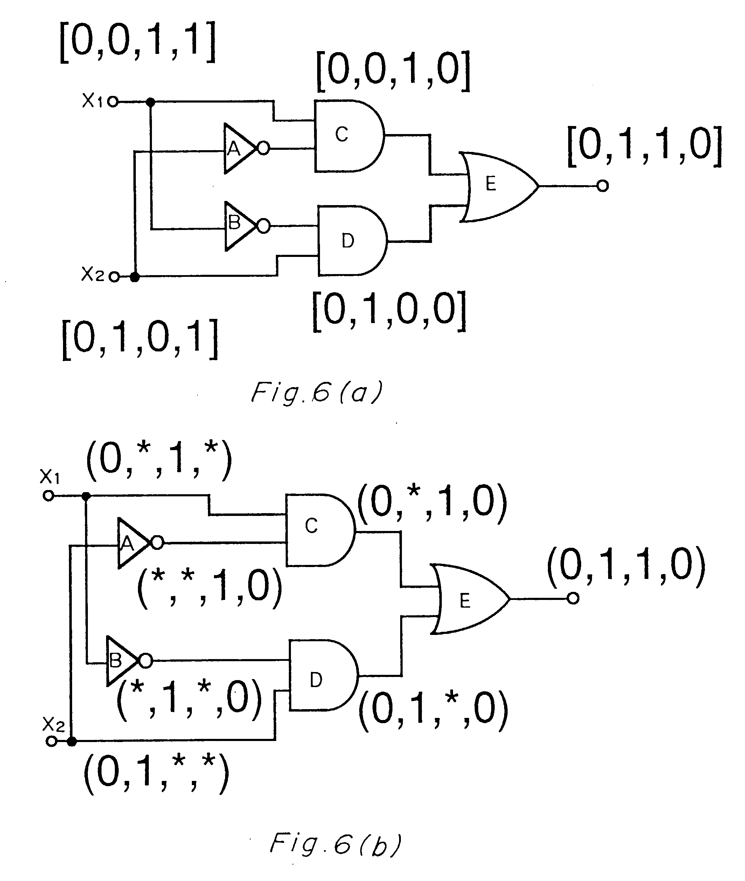

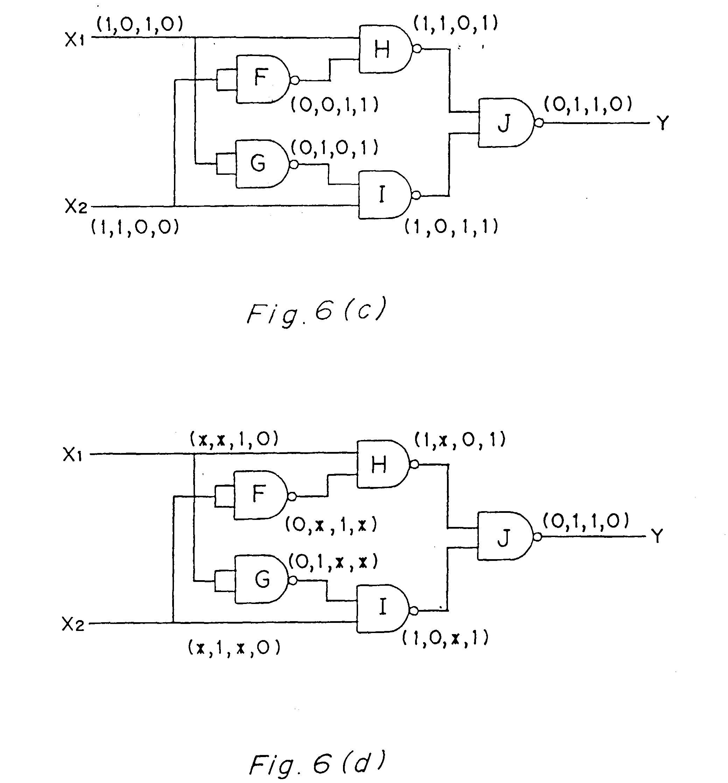

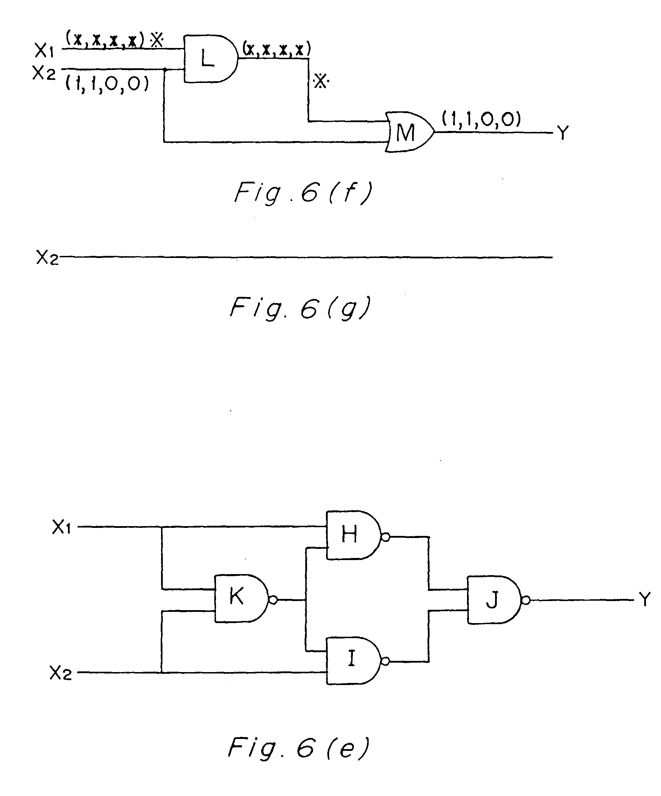

Figure 6 illustrates an example of logic functions and permissible functions of circuits and a circuit optimizing process using those functions. More specifically, Figure 6(a) illustrates the output logic of each of gates C, D and E when an input $X_1$ is changed in the order of 0, 0, 1, 1 and an input $X_2$ is changed in the order of 0, 1, 0, 1. Figure 6(b) illustrates permissible functions of the gates A, B, C and D and inputs $X_1$ and $X_2$ which keep the output of the circuit (gate E) in the order of 0, 1, 1, 0.

Figure 6(c) illustrates a logic circuit implemented with EX-OR circuits and Figure 6(d) illustrates permissible functions for the EX-OR circuits. In Figure 6(e), since the permissible functions of gates F and G in Figure 6(d) are common

$$(0, 1, 1, *),$$

gates F and G are merged into a gate K which implements the common part in their permissible functions.

Furthermore, Figures 6(f) and 6(g) illustrate a redundant-net removing process. A gate L with permissible function

$$(*, *, *, *)$$

and nets (inter-gate connections) in Figure 6(f) can be removed for conversion to a circuit with no redundancy, as shown in Figure 6(g).

In method B, no use is made of intermediate nodes so that, unlike the method A, there is no "combination of values that can never take place." However, a multistage expression of a logical expression containing intermediate nodes represents the topology of a circuit, while a truth table merely represents a logic function implemented by each node. Thus, it should be noted that a truth table is not a representation itself of a circuit. Therefore, a process slightly different from that in method A must be performed. Generally, to perform optimization, some transformation of an expression is performed such that a change in the logic function is involved in don't care conditions. (In method B, transformations are not performed indiscriminately to undergo subsequent checks. The kinds of transformations to be performed are determined previously from don't-care conditions. On this point, method B is quite distinct from method A.).

Method B also permits powerful optimization. In this case, however, the amount of memory must always be proportional to the exponent of an input variable. Furthermore, the same amount of trouble is necessary in calculation. Handling of a 10-to-20-input circuit is the limit of the fastest computers of today.

A paper by Fujita et al, entitled "Evaluation and improvements of Boolean comparison method based on binary decision diagrams", IEEE International Conference on CAD, ICCAD-88, Nov. 7-10, 1988, p.2-5, may be considered to disclose a logic circuit optimising method, for optimising a multistage logic circuit that has gates and inter-gate connections and is operable to receive a plurality of input variables and to produce an output variable having predetermined logical values in response to predetermined input-variable logical values or predetermined combinations of input-variable logical values, in which method a binary decision diagram is created to represent a function of a result variable produced at a specified gate or connection of the circuit, which function serves to assign logical values to the result variable in response to such predetermined input-variable logical values or such predetermined combinations of input-variable logical values, and the created diagram is processed to remove or scale-down redundant parts of the circuit without affecting the output-variable logical values produced by the circuit, the binary decision diagram being created by the steps of: determining an order of the said input variables; allocating the first-order input variable to a root of the diagram, allocating lower-order input variables, if any, to nodes of the diagram, and allocating the different assigned logical values to respective leaves of the diagram; and linking branches sequentially from the said root to the said leaves via the said nodes, if any, to form a tree structure, the root and each node having such a branch extending from it for each logical value that the input variable allocated to the root or node concerned can assume.

In this method, however, the binary decision diagrams produced only represent logical functions and therefore fail to take advantage of don't care conditions in the optimising process. Another paper by R.E. Bryant also discloses the basic way of creating such logical-function binary decision diagrams.

A logic circuit optimising method embodying the present invention is characterised in that the said binary decision diagram represents a permissible function of the said result variable, in which a don't care value is assigned to the result variable for any such predetermined input-variable logical value or predetermined combination of input-variable logical values in response to which the result variable is permitted to assume any logical value without affecting the said output-variable logical values; and in that, during creation of the permissible-function binary decision diagram, the said don't care value is allocated to a further leaf of the diagram.

One embodiment can permit the speeding up of an optimizing process for a multistage logic circuit by performing operations on two such binary decision diagrams representing respectively, for example, different functions of the logic circuit.

As a method of expressing a don't care condition, the present invention takes a form that uses only external inputs, as is the case with the conventional method B. The binary decision diagram used in the invention is a directed graph in which the order in which nodal points appear on a general binary decision tree is fixed and moreover partial trees of the same form are grouped. Binary decision diagrams of the same logic and the same order have the property of becoming the same form in all cases.

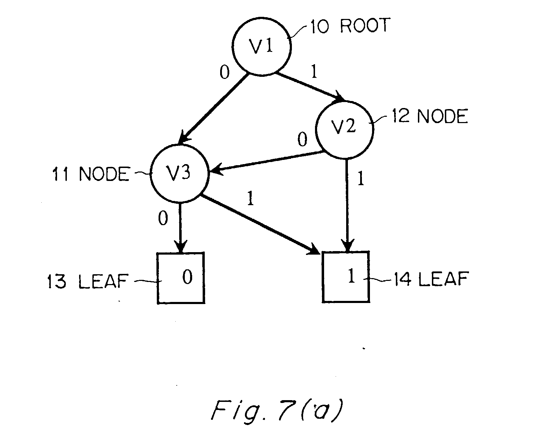

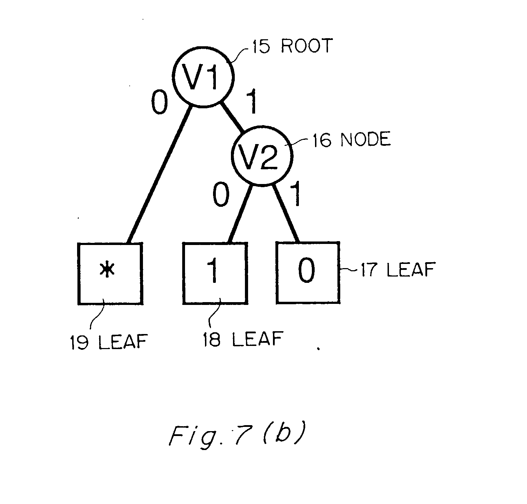

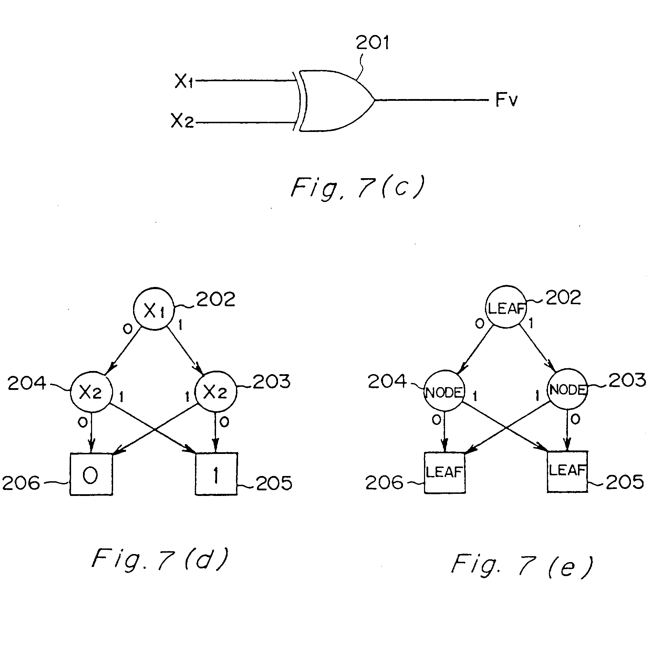

Figure 7 illustrates the principle of the present invention. Figure 7(a) illustrates an example of the binary decision diagrams of a logic function which represents $f = V_1 \cdot V_2 + V_3$. In the binary decision diagram of a logic function, the order of inputs, $V_1$, $V_2$ and $V_3$ in this example, is first decided and then the graph is created in accordance with this order.

The order of the inputs is $V_1$, $V_2$ and $V_3$ in this example. First, the input variable $V_1$ is handled as a root 10. Branches are extended from the root 10 to its right and left sides according to $V_1 = 1$ and $V_1 = 0$. When $V_1 = 1$, the corresponding branch leads to a node 12 having the input variable $V_2$ and branches extend therefrom according to $V_2 = 1$ and $V_2 = 0$. When $V_1 = 0$, on the other hand, the value for $V_2$ is unrelated to the output logic. Thus, the corresponding branch leads to a node 11 representing the input variable $V_3$. The output logic also depends on the input variable $V_3$ when the input variable $V_2 = 0$. Thus, the branch for $V_2 = 0$ leads to the node 11 of the input variable $V_3$. Finally, branches for $V_2 = 1$ and $V_3 = 1$ lead to a leaf 14 representing output logic 1, and the branch for $V_3 = 0$ leads to a leaf 13 representing output logic 0.

Figure 7(b) illustrates an example of a binary decision diagram representing a permissible function containing a don't care condition as well as 0, 1 as output logic. The method of creating the graph representing a permissible function is essentially the same as the method of creating the binary decision diagram representing a logic function of Figure 7(a). However, leaves representing output logic include a leaf 19 representing don't-care output, in addition to a leaf 17 representing output logic 0 and a leaf 18 representing output 1. This Figure shows that a don't-care output is produced. That is, the output logic can take either of 0 and 1 when $V_1 = 0$, 1 when $V_1 = 1$ and $V_2 = 0$, and 0 when $V_1 = V_2 = 1$.

Figures 7(c) through 7(e) illustrate a two-input EX-OR circuit and binary decision diagrams representing the logic function therefor. Using an input $X_1$ to the EX-OR circuit 201 of Figure 7(c) as the root 202, the other input $X_2$ as nodes 203 and 204 and the output $F_v$ as leaves 205 and 206 yields the binary decision graph of Figure 7(d). Figure 7(e) represents the binary decision diagram in terms of root, node and leaf in place of variable and output logic.

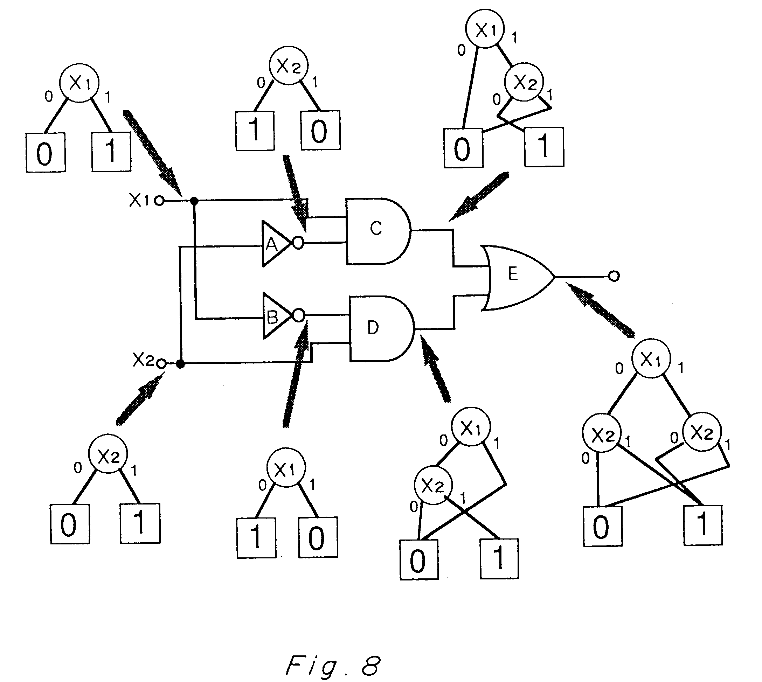

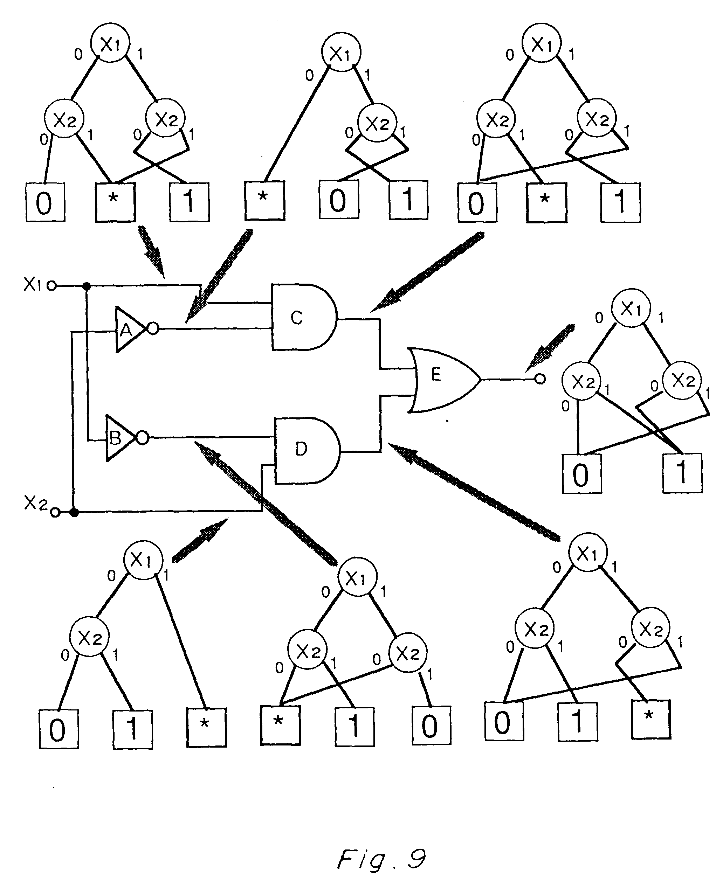

Figures 8 and 9 are binary decision diagrams representing logic functions and permissible functions corresponding to vector representation of the logic functions and permissible functions of Figure 6. More specifically, Figure 8 illustrates binary decision graphs representing logic functions of respective gates. These graphs can be drawn on the basis of vector representation of the logic functions of Figure 6(a). For example, the vector representation of the output of circuit (gate E) corresponds to the case where the input $X_1$ varies in the order 0, 0, 1, 1 and the input $X_2$ varies in the order 0, 1, 0, 1. The binary decision diagram representing the output logic function of the gate E can be drawn from the vector representation.

The binary decision diagram of a net supplied with input variable $X_1$ can be drawn based on the fact that logic 1 is obtained when $X_1 = 1$ and logic 0 is obtained when $X_1 = 0$. Although the logic function of the output of gate (inverter) A is not shown in Figure 6, it is natural that the binary decision diagram representing the logic function of its output can be drawn as shown because the output of the inverter A results from the inversion signal of input variable $X_2$.

The binary decision diagrams representing permissible functions in Figure 9 can be drawn from vector representations of permissible functions of Figure 6 (b). The permissible function of the circuit (gate E) contains no don't-care condition. Thus, its binary decision diagram is exactly the same as in Figure 8. Binary decision diagrams representing don't care are drawn for the other portions as shown in correspondence with Figure 6(b).

In an optimizing method for a multistage logic circuit embodying the present invention, optimising is performed using such binary decision diagrams representing permissible functions as described above. This is achieved by the method set out in claim 1. Binary decision diagrams representing logical functions may also be used in addition to the permissible-function diagrams.

Reference will now be made, by way of example, to the accompanying drawings, in which:

Figure 1 illustrates an example of a general flow of a logic synthesizing process,

Figure 2 illustrates an example of a multistage logic network,

Figures 3(a) and 3(b) illustrate examples of a logic optimizing process,

Figure 4 illustrates an example of a don't-care condition in a multistage network according to method A,

Figure 5 illustrates an example of a don't-care condition in a multistage network according to method B,

Figures 6(a) through 6(g) illustrate examples of vector representations of logic functions and permissible functions of circuits,

Figures 7(a) through 7(e) are diagrams for explaining the principle of the present invention,

Figure 8 illustrates examples of binary decision diagrams representing logic functions of circuits,

Figure 9 illustrates examples of binary decision diagrams representing permissible functions of circuits,

Figure 10 is a flowchart of an embodiment of an optimizing process for a multistage logic circuit using two binary decision graphs,

Figure 11 is a flowchart of an embodiment of a binary decision diagram representing a logic function,

Figure 12 is a flowchart of an embodiment of a binary decision diagram representing a permissible function,

Figure 13 is a diagram illustrating an embodiment of the intersection of two binary decision graphs,

Figure 14 illustrates a circuit in which a gate A and a gate B are merged,

Figures 15(a) through 15 (j ) are diagrams illustrating embodiments for performing OR operations on two binary decision diagrams,

Figure 16 illustrates an embodiment of a program for a gate merging process,

Figure 17 illustrates an embodiment of a program for performing operations on two binary decision diagrams,

Figure 18 illustrates an embodiment of classification of non-terminal points in a binary decision diagram,

Figures 19(a) to 19(c) illustrate an embodiment of a process of transforming a binary decision diagram (part 1),

Figures 20(a) through 20(f) illustrate the other embodiment of the binary decision diagram transforming process (part 2),

Figure 21 is an illustration of the output logic of a circuit in the form of a truth table, a sum-of-products logic expression and a binary decision diagram, and

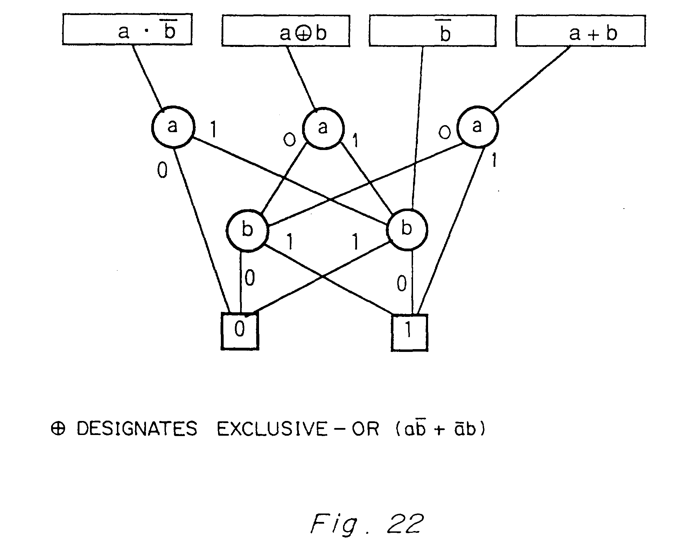

Figure 22 illustrates an example of a shared binary decision diagram representing a plurality of logic functions.

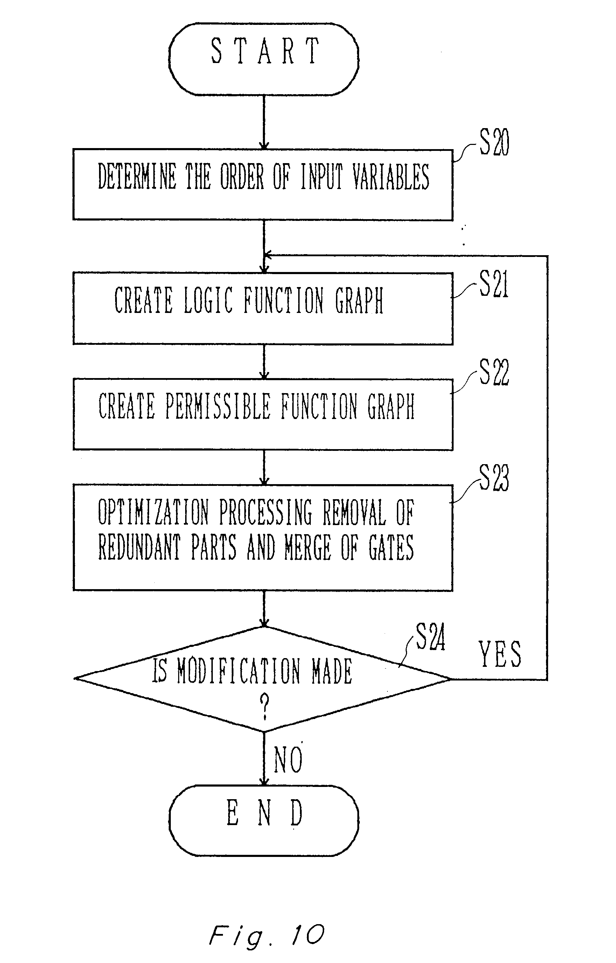

In the present invention, an optimizing process for a multistage logic circuit is performed using binary decision diagrams representing permissible functions (binary decision diagrams representing logical functions may also be used in addition to the permissible function diagrams). The binary decision diagrams are created first. The creation of those binary decision diagrams is described based on the vector representation of Figure 6 with reference to Figures 8 and 9. In general, the binary decision diagrams are create in accordance with the flowcharts Illustrated in Figures 10 to 12.

Figure 10 is a flowchart for an embodiment of a multistage logic circuit optimizing process using binary decision diagrams. In this Figure, first, in S (step) 20, the sequence of input variables is determined to create binary decision diagrams. In step S21, binary decision diagrams for logic functions are created and in step S22, binary decision diagrams for permissible functions are created. Next, in step S23, an optimizing process involving removal of redundant parts and merge of gates is performed. In step S24, a determination is made as to whether or not a modification has been made in the logic circuit as a result of the optimizing process. If modification has been made, the modified part is subjected to the process from step S21 again. If no modification has been made, the processing terminates.

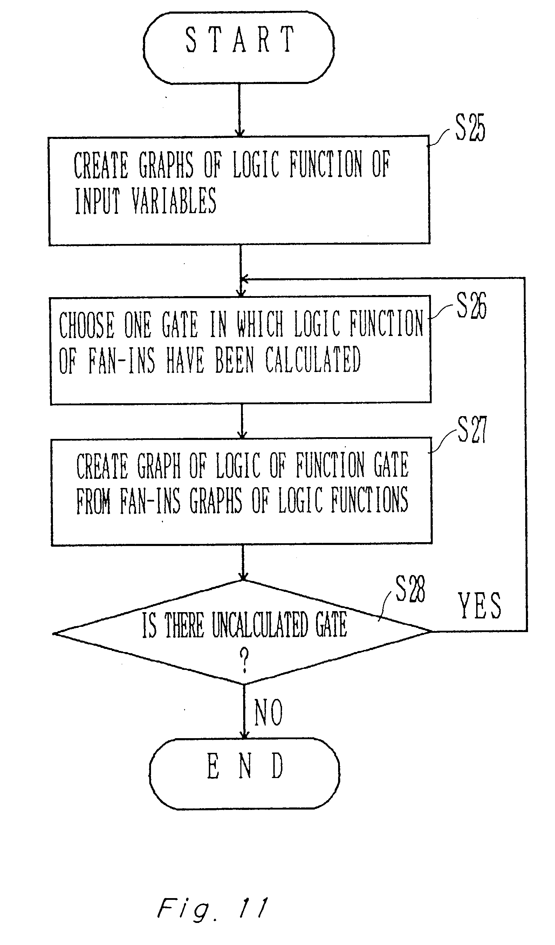

Figure 11 is a flowchart of the creation process of binary decision diagrams for logic functions in step S21 of Figure 10. In this Figure, first, in step S25, binary decision diagrams for the input variables are created. For example, this corresponds to creation of a binary decision diagram representing the logic function of the net supplied with the input variable $X_1$ in Figure 8. In step S26, one gate in which the logic states of its fan-in have all been calculated is chosen. In Figure 8, this gate corresponds, for example, to gate A. In step S27, the binary decision diagram representing the logic function of the gate is created from binary decision diagrams for the fan-in logic.

Assuming that gate A has been chosen in step S26, the binary decision diagram for output of the gate A is created in step S27. In step S28, a determination is made as to whether or not there is a gate which has not yet been calculated. If there is an uncalculated gate, the processing steps are repeated from step S26. If there is no uncalculated gate, the process terminates. When the binary decision diagram for the output of gate A is created in step S27, the gate to be chosen next in step S26 is either gate B or gate C, and this gate is processed in step S27.

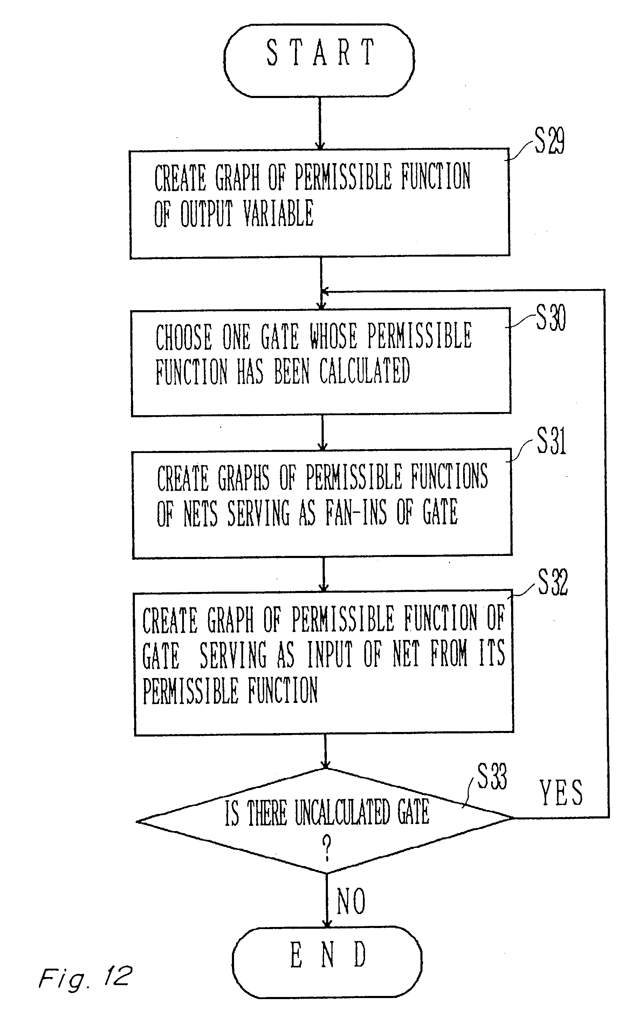

Figure 12 is a flowchart of an embodiment of step S22 in Figure 10, i.e., the process of creating a binary decision diagram representing a permissible function. In this Figure, first, in step S29, a binary decision diagram representing a permissible function of an output variable is created. That is, the creation of binary decision diagrams for permissible functions is performed from the output side of the logic circuit. This is opposite to the case of Figure 11 in which the creation is performed from the input side. Next, in step S30, one gate whose permissible function has been calculated is chosen. This is gate E in Figure 9. In step S31, binary decision diagrams representing permissible functions for the nets constituting fan-ins of the gate are created. For gate E there are two fan-in nets which come from gates C and D. The binary decision diagrams for those nets are created simultaneously.

In step S32, binary decision diagrams are created representing permissible functions for the gates providing inputs to the nets on the basis of the permissible functions for the calculated nets. The binary decision diagrams for gates C and D are thereby created herein. In step S33, the presence or absence of an uncalculated gate is determined. If an uncalculated gate is present, the above steps are repeated from step S30. If one is not present, the process terminates.

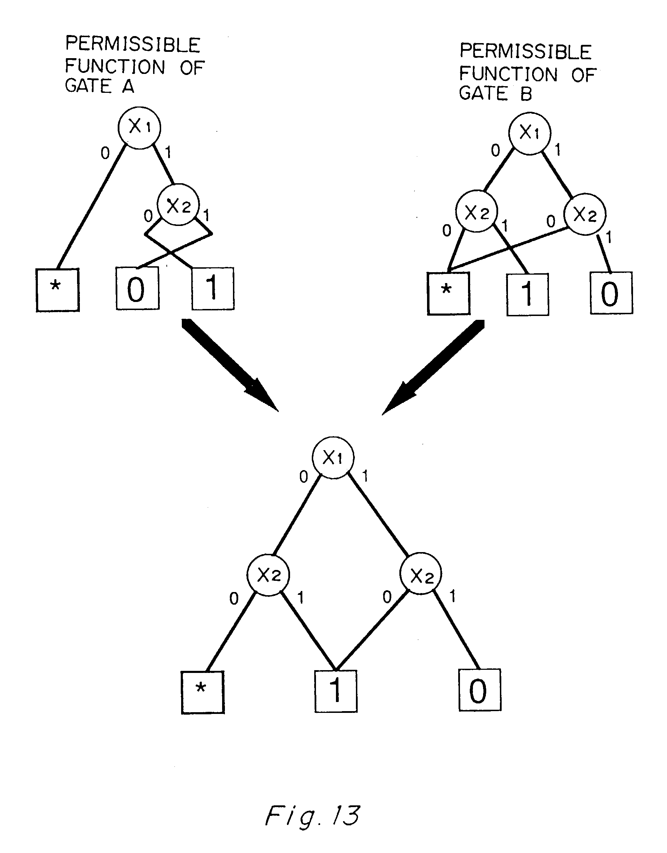

Figure 13 illustrates an embodiment of a process of merging two binary decision diagrams, i.e., an intersection. In this Figure, intersection is taken between the binary decision diagrams representing the permissible functions for the outputs of gates A and B of Figure 9. When $X_1 = 0$ on the side of gate A, the output logic is don't-care and is independent of the $X_2$ logic. After the intersection this may be changed such that don't-care output logic is obtained when input variable $X_2 = 0$ and 1 output logic is obtained when $X_2 = 1$. On the side of gate B, the output logic is don't care when $X_1 = 1$ and $X_2 = 0$. It doesn't matter if the output logic is changed to 1 after the intersection.

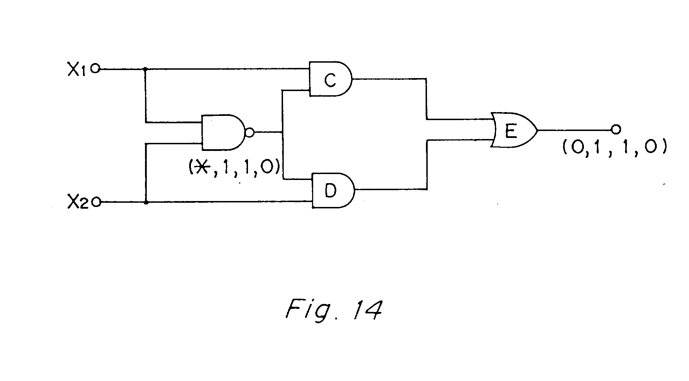

As a result of the intersection of Figure 13, the gate corresponding to the merged binary decision diagrams for the gates A and B of Figure 9 is realized with a NAND gate. Figure 14 therefore illustrates the permissible function of the gate into which gates A and B are merged.

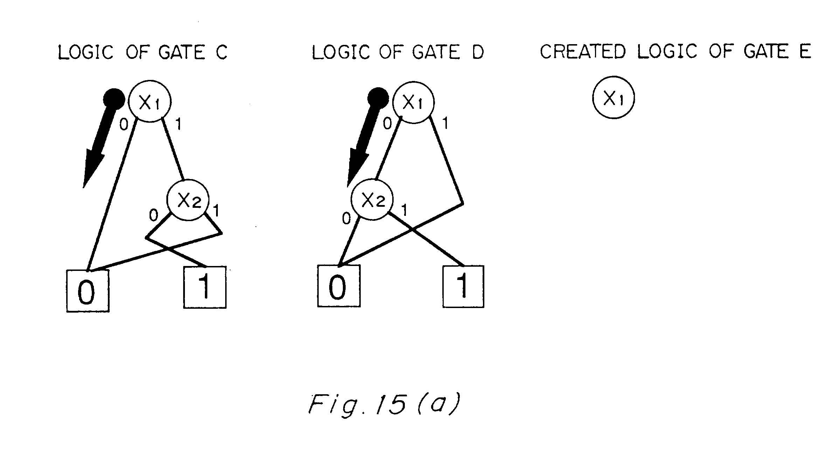

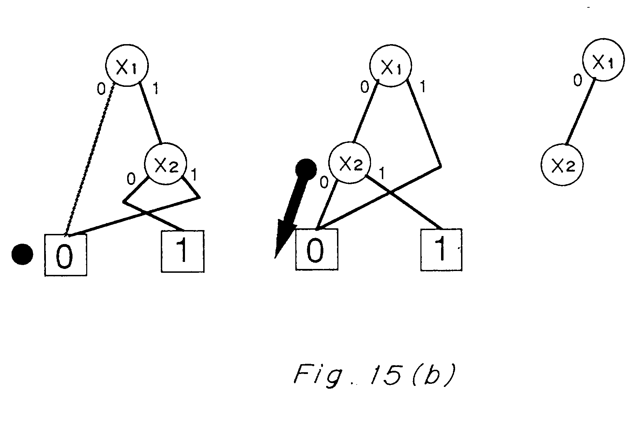

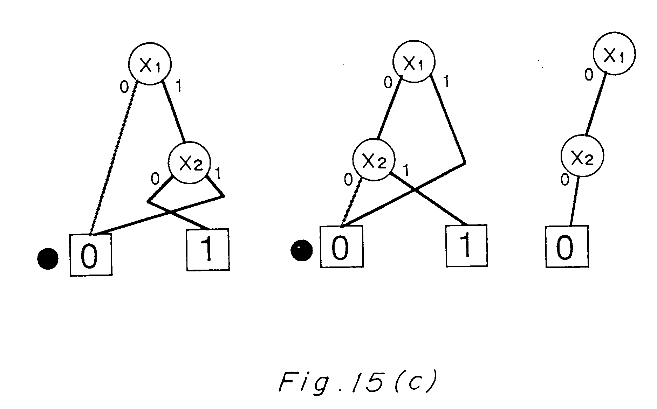

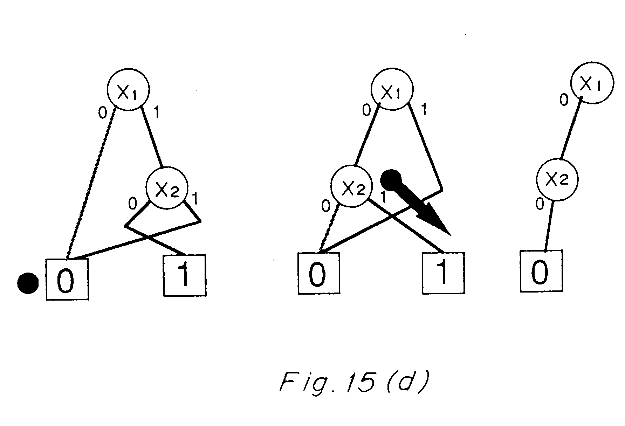

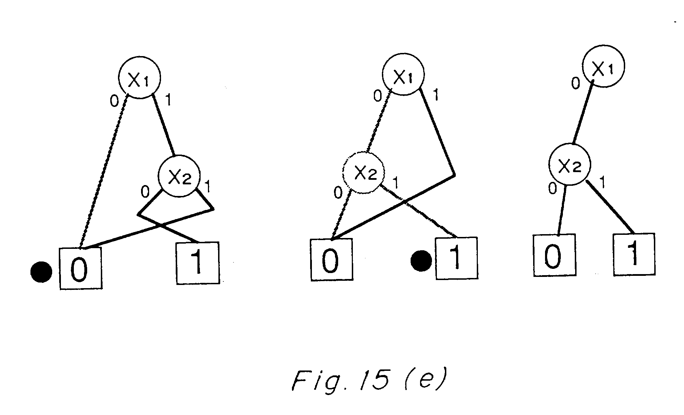

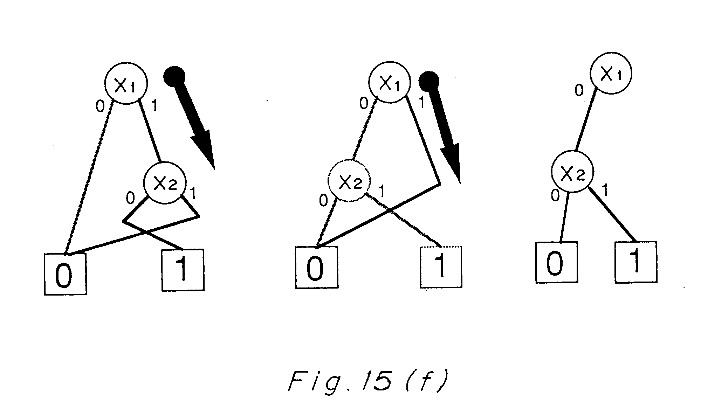

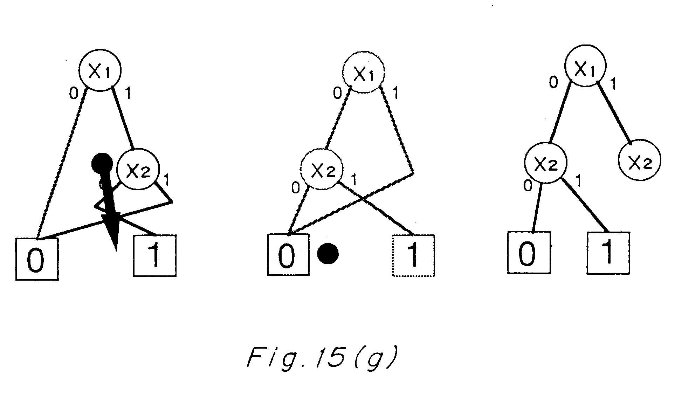

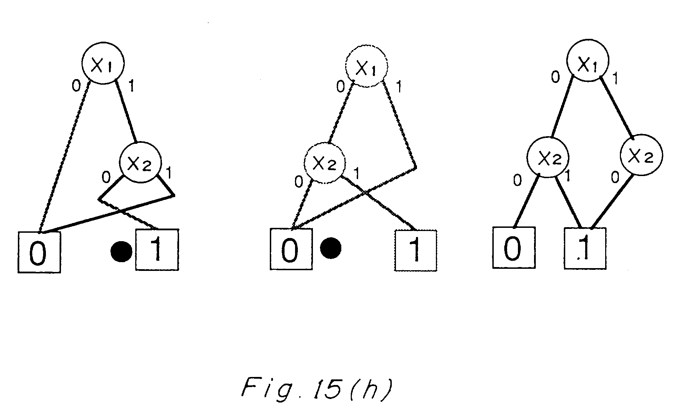

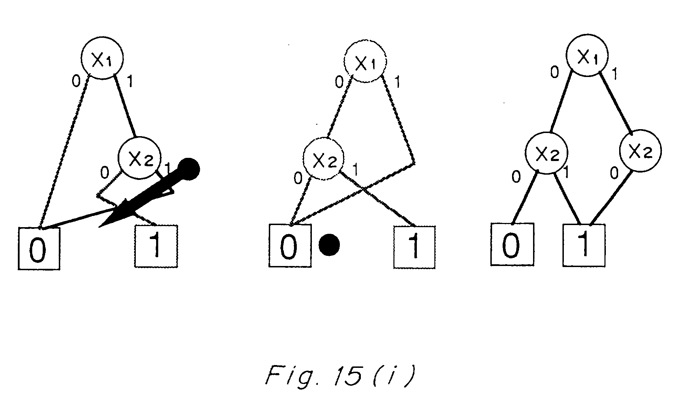

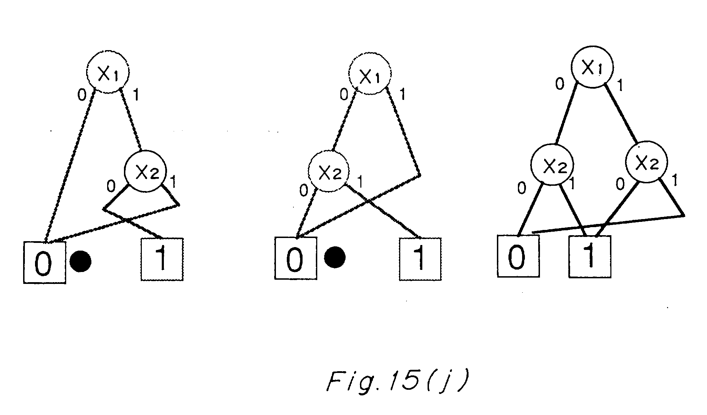

Figure 15 illustrates a process of performing an operation on two binary decision diagrams, an OR operation in this embodiment. In such operational processing, each of the two binary decision diagrams is traced from the root in the direction of the same logic of an input variable corresponding to the root or a node on the graphs, and when a leaf is reached on each of the two binary decision diagrams, a logical operation is performed on them. Such processing, beginning with the root, is repeated for each combination of input variables.

In Figure 15, operational processing is performed to create the binary decision diagram of gate E which ORs the output of gate C with the output of gate D in Figure 8. In Figure 15(a), the binary decision diagrams for gates C and D are each traced from their roots in the case of input variable $X_1 = 0$. In Figure 15(b), a leaf representing output logic 0 is reached in the binary decision diagram for gate C. In the binary decision diagram for gate D, a node having a variable $X_2$ is reached and the graph is traced again from the node in the direction of $X_2 = 0$. In the binary decision diagram for gate D as well, a leaf representing output logic 0 is reached as shown in Figure 15(c). As a result, the output logic of the leaf reached in the binary decision diagram for gate C is ORed with the output logic of the leaf in the binary decision diagram for gate D. In this case, the ORing of 0 and 0 produces 0. The resultant part of the binary decision diagram for gate E represents that the output logic becomes 0 when input variable $X_1 = X_2 = 0$.

Subsequently, the processing for other logical combinations of input variables $X_1$ and $X_2$ is continued. In Figure 15(d), the binary diagrams are traced for $X_1 = 0$ and $X_2 = 1$. For gate C, the leaf representing output logic 0 is already reached. For gate D the binary decision diagram is traced. As a result, the leaf representing output logic 1 is reached on the binary decision diagram for gate D, as shown in Figure 15(e).

The logic 0 of the leaf for gate C and the logic 1 of the leaf for gate D are ORed. Thus, the resultant output logic of gate E will be 1.

Next, in Figure 15(f), the binary decision diagrams for gates C and D are traced from their roots in the direction of $X_1 = 1$. As shown in Figure 15(g), the leaf representing output logic 0 is reached on the side of gate D, while the binary decision diagram is traced in the direction of $X_2 = 0$ on the side of gate C. Consequently, as shown in Figure 15(h), the leaf representing output logic 1 is reached on the side of gate C as well. The ORing of the two leaves representing 1 and 0 is performed so that the resultant output logic will become 1 on the binary decision diagram for gate E. Next, the binary decision diagrams are traced for $X_1 = X_2 = 1$ as shown in Figures 15(i) and 15(j) so that the binary decision diagram for gate E is completed as shown in Figure 15(j).

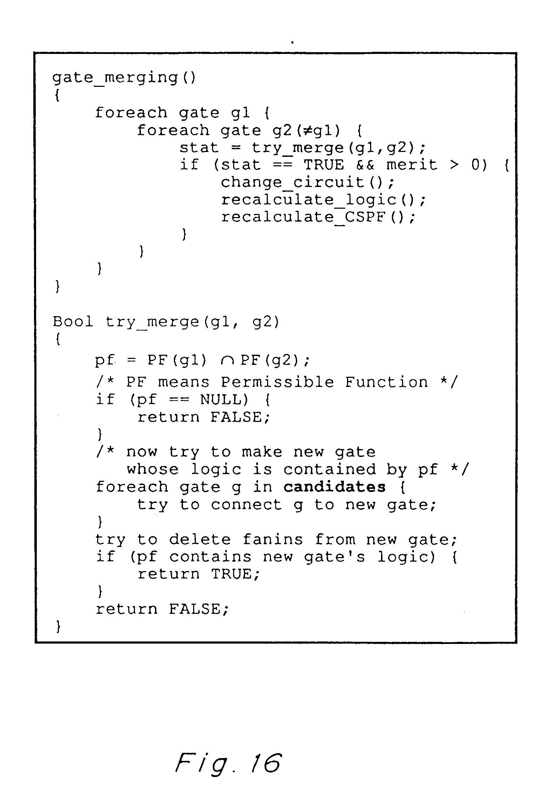

Figure 16 illustrates an embodiment of a program for intersection of two binary decision diagrams as shown in Figure 13, i.e., a gate merge application program. Whether or not two gates g1 and g2 can be merged is examined for all combinations of gates constructing a multistage logic circuit. First, gate g2 is changed to examine whether or not a gate or gates g2 can be merged with a certain gate g1. Next, gate g1 is changed to another one to examine whether or not a gate or gates g2 can be merged with the new gate g1.

The "try merge" is a process for determining whether or not the merge of gates is possible. First, an examination is made as to whether or not there is a common part p5 between permissible functions PF for two gates g1 and g2. If the common set is null, a merge is impossible. If not null, there is the possibility of a merge between gates g1 and g2. If there is the possibility of a merge, an examination is made as to whether or not a gate which can satisfy the conditions can be made and then the process terminates.

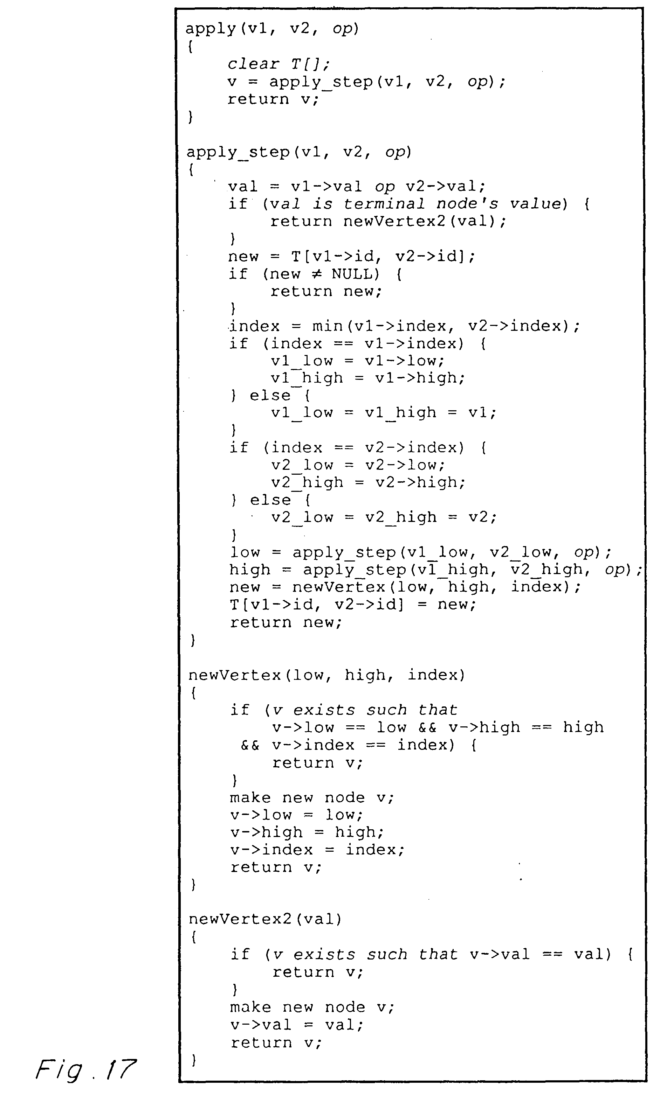

Figure 17 illustrates an embodiment of a program of operational processing of two binary decision diagrams as illustrated in Figure 15. In the Figure, the operation on binary decision graphs is performed by a process called "apply". In Figure 17, in the first step of the function "apply_step", the following calculation is performed.

val = v1- > val op v2- > val ;

For example, in the case of an OR operation, ORing is performed instead of the above op. v1- > val refers to values for a node v1 which is a general term for the root, nodes and leaves of a binary decision diagram. Terminal nodes (leaves) have values of 0 and 1 (terminal node values), while non-terminal nodes (intermediate nodes) have a value of X. With three such values of 0, 1 and X used as elements, the OR operation is defined such that 0OR0= 0, 0OR1 = 1, 0ORX = 1, 1OR0 = 1, 1OR1 = 1, 1ORX = 1, XOR0 = X, XOR1 = 1 and XORX = X. (This corresponds to the case of a binary decision diagram having two values 0 and 1 as terminal node values. A little more complexity will result in the case of a binary decision diagram having three values, which contain * representing a permissible function, as terminal node's values.) The AND operation and the like will be defined likewise.

The "index" in Figure 17 represents the correspondence between each node (root and nodes) and an input variable in a binary decision diagram. For example, in Figure 7(a), the index of the root 10 is $V_1$ and the index of the node 11 is $V_3$. As illustrated in Figures 8 and 9, a plurality of nodes may have the same index.

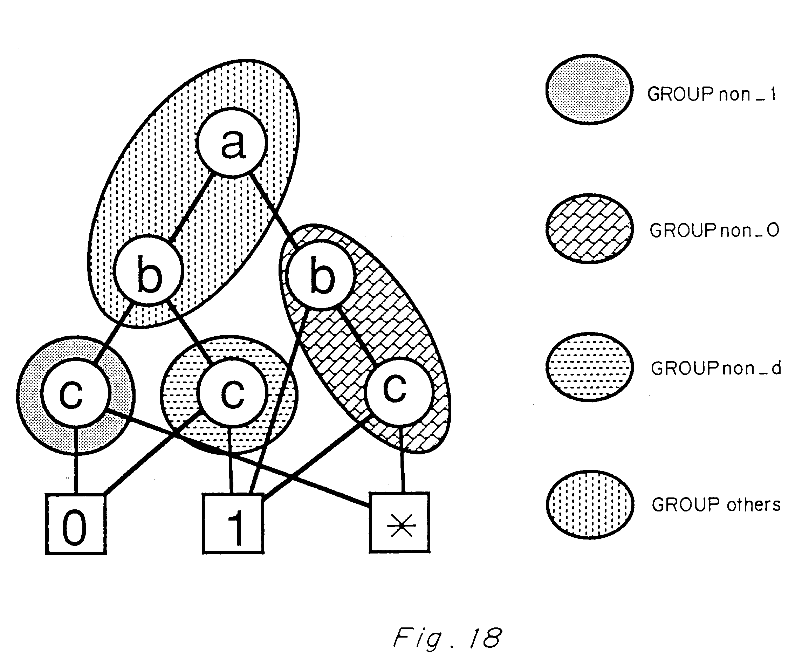

Figure 18 illustrates the classification of non-terminal points other than leaves, or the root and nodes in a binary decision diagram representing a permissible function. In the Figure, the non-terminal points are classified into four groups, i.e., group non 1 that is never connected to the leaf of logic 1, group non 0 that is never connected to the leaf of logic 0, group non d that is never connected to the leaf of don't care and group others.

As described in conjunction with Figure 15, in the operation on two binary decision diagrams, the points are traced so that identical variables may have identical values, and each time the graphs are traced to leaves, the operation is performed using logical values of the leaves. In the case of operation on binary (two-valued) variables, when, for example, the logical product is computed between two binary decision diagrams, the computed result will be found to be 0 when the leaf of output logic 0 is reached on one of the graphs. Thus, a returning process of the result is performed without further tracing the binary decision diagrams.

In the operation on three-valued variables containing a don't-care variable, the operation on two binary decision diagrams will become more complex. When a check is made for the case where a value becomes 0 in certain conditions, if a non-terminal point belonging to the group non 0 is reached when the binary decision diagrams are being traced, then it will be found that the point does not lead to the leaf of output logic 0. At this point the search can be canceled, thus improving the efficiency of operational processing.

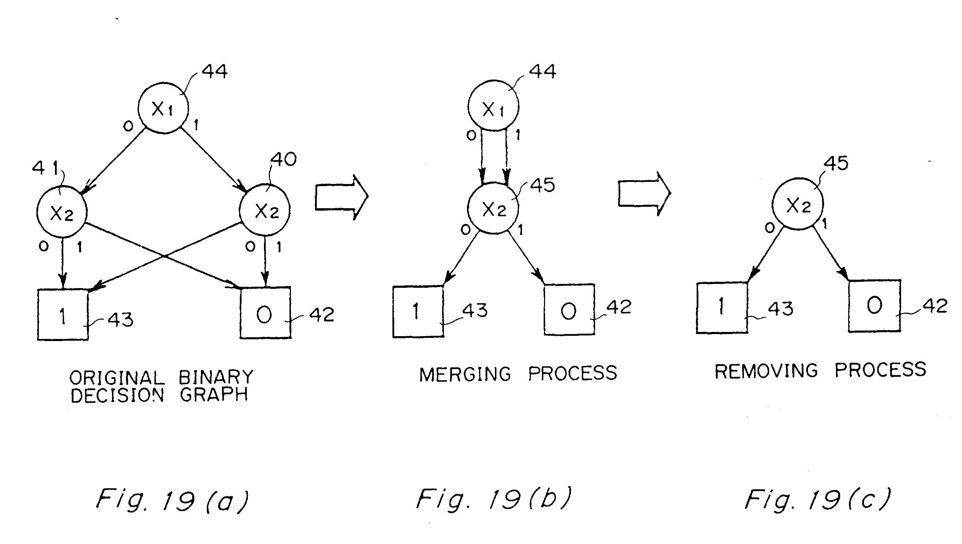

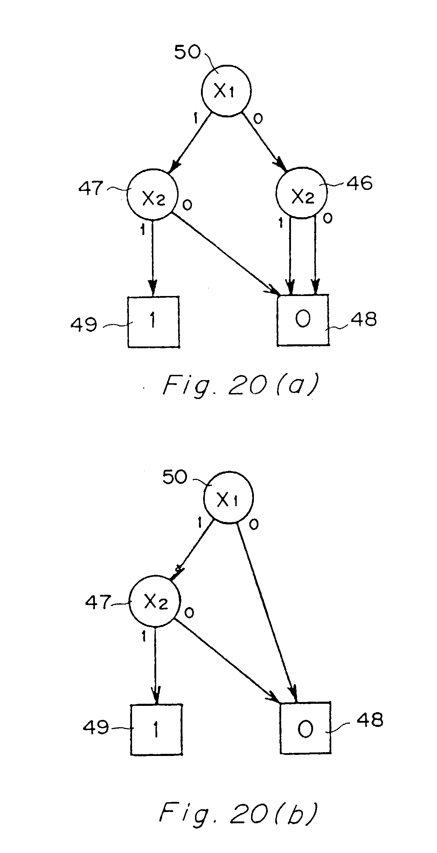

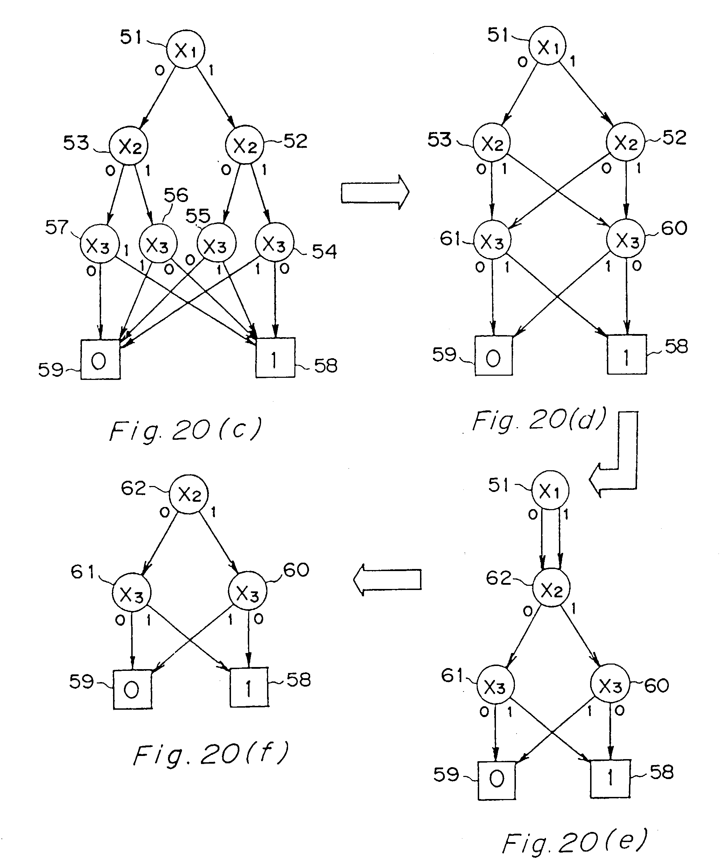

Figures 19 and 20 illustrate examples of a process of transforming binary decision diagrams. Figure 19(a) is an original binary decision diagram in which nodes 40 and 41, having an input variable of $X_2$ of the last order, point to the leaf 42 representing output logic 0 when $X_2 = 1$ and to the leaf 43 representing output logic 1 when $X_2 = 0$. Thus, these nodes can be merged into one node 45 as shown in Figure 19(b). Furthermore, in Figure 19(b), the root 44 points to the node 45 regardless of whether the input variable $X_1$ of the highest order takes either 0 or 1. Thus, the input variable $X_1$ of the highest order is removed herein for transformation into a binary decision diagram shown in Figure 19(c).

Figures 20(a) and 20(b) are binary decision diagrams for a two-input AND circuit. In the original binary decision diagram of Figure 20(a), a node 46 points to the same leaf 48 in both cases of its input variable $X_2 = 0$ and $X_2 = 1$. For this reason, the input variable to the node can be removed as shown in Figure 20(b).

Figures 20(c) to 20(f) illustrate a binary decision diagram representing a logic function of a three-input circuit for providing an output of

$$X_1 \cdot (X_2 \cdot X_3 + X_2 \cdot X_3) + X_1 \cdot (X_2 \cdot X_3 + X_2 \cdot X_3)$$

and its conversion process. In the original graph of Figure 20(c), nodes 54 and 56, having a variable $X_3$, both point to a leaf 58 when $X_3$ is 0 or the other leaf 59 when $X_3$ is 1. Likewise, nodes 55 and 57, having the variable $X_3$, point to leaf 58 when $X_3$ is 1 or leaf 59 when $X_3$ is 0. Thus, nodes 54 and 56 are merged into a node 60 and the nodes 55 and 57 are merged into a node 61 as shown in Figure 20(d). In Figure 20(d), nodes 52 and 53 having an input variable $X_2$ point to node 60 when $X_2$ is 1 or to node 61 when $X_2$ is 0. Thus, these nodes 52 and 53 are merged into a node 62 as shown in Figure 20(e). Furthermore, in Figure 20(e), the root 51 having an input variable $X_1$ points to the node 62 in both cases of $X_1 = 1$ and $X_1 = 0$. Therefore, the root 51 can be removed and finally the graph of Figure 20(f) will be obtained.

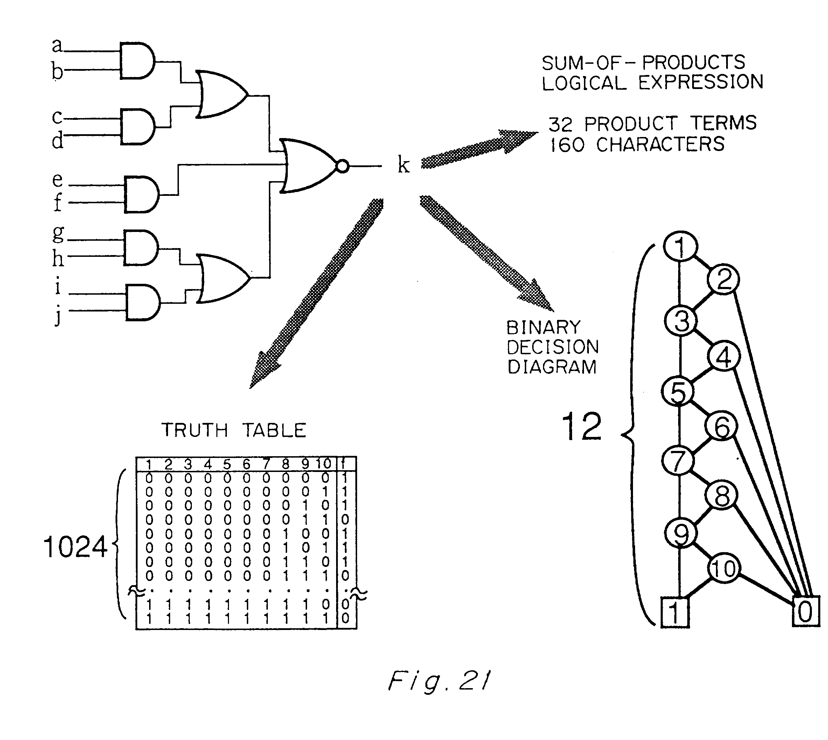

Figure 21 illustrates an example of representation of the output logic of a circuit in terms of a truth table, a sum-of-products logical expression and a binary decision diagram. The truth table always requires $2^n$ rows (n being the number of inputs) and the two-stage sum-of-products logical expression requires 32 product terms. The negation (= ab + cd + ef + gh + ij) of the logic can be expressed by use of five product terms, i.e., ten characters. However, the affirmation of the logic will not be expressed compactly.

The expansion of (a + b) (c + d) (e + f) (g + h) (i + j) will result in 32 product terms, i.e., 160 characters. In a multistage network, the affirmative logic and the negative logic of the same node are frequently utilized.

It is a serious drawback that a two-stage sum-of-products logical expression has no symmetric property for affirmative and negative expressions. In the case of a binary decision diagram, this example of logic can be expressed with ten non-terminal points and two terminal points. The negation of the logic can also be expressed with the same number of graphs (1 and 0 are merely interchanged).

According to the present invention, as described above, not only a single logic function can be expressed compactly, but also many logic functions can be expressed efficiently by sharing parts of the same form in partial graphs between binary decision diagrams representing a plurality of logic functions. This feature is very useful in reducing the amount of memory in optimizing a multistage logic circuit, in which case a logic function and don't-care conditions need to be retained for each node. This is impossible to realize with expressions by a truth table and a sum-of-products logical expression. A logic-circuit optimizing method embodying the present invention is used to optimize a multistage logic circuit and is useful for automatic synthesis of multistage logic circuits using a computer.

## Claims

1. A logic circuit optimising method, for optimising a multistage logic circuit that has gates (A to E) and inter-gate connections and is operable to receive a plurality of input variables (X1,X2) and to produce an output variable having predetermined logical values (0,1,1,0) in response to predetermined input-variable logical values or predetermined combinations of input-variable logical values (X1:0,0,1,1;X2: 0,1,0,1), in which method a binary decision diagram is created to represent a function of a result variable produced at a specified gate (e.g. C) or connection of the circuit, which function serves to assign logical values (0,0,1,0) to the result variable in response to such predetermined input-variable logical values or such predetermined combinations of input-variable logical values (X1:0,0,1,1;X2:0,1,0,1), and the created diagram is processed to remove or scale-down redundant parts of the circuit without affecting the output-variable logical values produced by the circuit, the binary decision diagram being created by the steps of:

   determining an order (X1,X2) of the said input variables;
   allocating the first-order input variable (X1) to a root of the diagram, allocating lower-order input variables (X2), if any, to nodes of the diagram, and allocating the different assigned logical values (0,1) to respective leaves (0,1) of the diagram; and
   linking branches sequentially from the said root to the said leaves via the said nodes, if any, to form a tree structure, the root and each node having such a branch extending from it for each logical value (0,1) that the input variable (X1; X2) allocated to the root or node concerned can assume;

   characterised in that the said binary decision diagram represents a permissible function of the said result variable, in which a don't care value (*) is assigned to the result variable for any such predetermined input-variable logical value or predetermined combination of input-variable logical values (X1 = 0, X2 = 1) in response to which the result variable is permitted to assume any logical value without affecting the said output-variable logical values;

   and in that, during creation of the permissible-function binary decision diagram, the said don't care value (*) is allocated to a further leaf (*) of the diagram.

2. A method as claimed in claim 1, wherein a logical-function binary decision diagram is also created to represent the logical function of such a result variable, which logical function serves to assign to that result variable only predetermined logical values (0,1) and does not serve to assign thereto such a don't care value (*), and the created logical-function binary decision diagram is processed to effect such removal or scaling-down of redundant parts of the circuit, the said logical-function binary decision diagram being created by the steps of:

   determining an order (X1, X2) of the said input variables;
   allocating the first-order input variable (X1) to a root of the diagram, allocating lower-order input variables (X2), if any, to nodes of the diagram, and allocating the different logical values (0,1) assigned by the said logical function to respective leaves (0,1) of the diagram; and
   linking branches sequentially from the said root to the said leaves via the said nodes, if any, to form a tree structure, the root and each node having such a branch extending from it for each logical value (0,1) that the input variable (X1; X2) allocated to the root or node concerned can assume.

3. A method as claimed in claim 2, comprising the steps of:

   (a) determining the order of said input variables (X1, X2) of said multistage logic circuit (S20);
   (b) creating such a logical-function binary decision diagram, representing such a logical function, for each said gate (A to E) and connection of said circuit (S21) ;

(c) creating such a permissible-function binary decision diagram, representing such a permissible function, for each said gate and connection of said circuit (S22) ;

(d) optimising the circuit by seeking to remove said redundant parts of said circuit and to merge gates thereof using the created logical-function and permissible-function binary decision diagrams (S23) ; and

(e) determining whether or not a change has been made in said circuit as a result of the optimising in step (d) (S24); and

repeating steps (b) to (e) if it is determined in step (e) that such a change was made and terminating the processing if it is determined in step (e) that no such change was made in said circuit.

4. A method as claimed in claim 3, wherein the said step (b) (S21) comprises the steps of:

(b1) creating such a logical-function binary decision diagram for each said input variable (X1,X2) (S25);

(b2) choosing, from among the said gates (A to E) of the multistage logic circuit, one gate (eg A) for which such logical-function binary decision diagrams have already been created for every fan-in of the gate (S26);

(b3) creating such a logical-function binary decision diagram for the output of the chosen gate (A) (S27);

(b4) determining whether or not there is an uncalculated gate (B,C), being a gate for which no such logical-function binary decision diagram for the gate output has yet been created (S28); and

repeating the steps (b2) to (b4) (S26 to S28) if it is determined in step (b4) that there is such an uncalculated gate and terminating the processing if it is determined in the step (b4) that there is no such uncalculated gate.

5. A method as claimed in claim 3 or 4, wherein the said step (c) comprises the steps of:

(c1) creating such a permissible-function binary decision diagram for the said output variable (E) of said multistage logic circuit (S29);

(c2) choosing a gate (eg E) for the output of which such a permissible-function binary decision diagram has already been created (S30);

(c3) creating respective permissible-function binary decision diagrams for connections (C→E, D→E) which are fan-ins of the gate (E) chosen in step (c2) (S31);

(c4) creating respective such permissible-function binary decision diagrams for outputs of gates (C,D) providing inputs to the fan-in connections (C→E, D→E) for the chosen gate (E) of step (c2) based on the created permissible-function binary decision diagrams for those fan-in connections (S32);

(c5) determining whether or not there is an uncalculated gate (A,B), being a gate for which no such permissible-function binary decision diagram has yet been created (S33); and

repeating steps (c2) to (c5) if it is determined in the step (c5) that there is such an uncalculated gate and terminating the processing if it is determined in the step (c5) that there is no such uncalculated gate (S33).

6. A method as claimed in any preceding claim, in which an intersection operation (Figure 13) is performed between respective such permissible-function binary decision diagrams for the outputs of two gates (A,B) by attempting to change a branch, representing such a predetermined combination of input-variable logical values, that is currently linked to the said further leaf (*) so that the branch terminates instead at one of the said leaves (0,1) to which one of the said different assigned logical values (0,1) is allocated, thereby creating a further permissible-function binary decision diagram for a gate into which the said two gates (A,B) are merged.

7. A method as claimed in any preceding claim, wherein, in order to create a new logical-function or permissible-function binary decision diagram for the output of a selected gate (E) that is operable to perform a predetermined logic operation (eg OR), based on two existing logical-function or two existing permissible-function binary decision diagrams relating respectively to the outputs of two further gates (C,D) serving as fan-ins of the said selected gate (E), for each in turn of the said predetermined input-variable logical values or predetermined combinations of input-variable logical values (e.g. X1=0, X2=0), the said two existing binary decision diagrams are traced from their respective roots (X1) along mutually-corresponding branches to reach the appropriate leaf (leaf 0 of C diagram, leaf 0 of D diagram in Figure 15b) of each diagram, the said predetermined logic operation (OR) is performed on the logical values (0,0) allocated to the leaves reached respectively on the two existing binary decision diagrams so as to determine the logical value (0) to be allocated to a leaf of the said new binary decision diagram for the predetermined input-variable logical value or predetermined combination of input-variable logical values concerned (0,0).

8. A method as claimed in any preceding claim, wherein, in such a permissible-function binary decision diagram (Figure 18), the root and nodes other than leaves are classified into four non-terminal point groups consisting of group "non 1" the members of which are never linked with a leaf allocated to the logical value 1, group "non 0" the members of which are never linked with a leaf allocated to the logical value 0, group "non d" the members of which are never linked with the said further leaf, and group "others", thereby speeding up operational processing between two such binary decision diagrams.

9. A method as claimed in any preceding claim, in which such a permissible-function or logical-function binary decision diagram (Figure 19a) is transformed into another binary decision diagram (Figure 19b) by combining, as one node (45), any two or more nodes (40, 41), allocated commonly to the input variable (X2) of the lowest order in the diagram to be transformed, that are linked to the same set of leaves (42, 43) by corresponding sets of branches.

10. A method as claimed in any preceding claim, wherein, in such a permissible-function or logical-function binary decision diagram, when the root (44), or a node allocated to an input variable (X1) of one order, branches to the same node (45), being a node allocated to an input variable (X2) of lower order than the said one order, or branches to the same leaf, for each logical value (1,0) that the input variable (X1) of the said one order can assume, the binary decision diagram is transformed into a binary decision diagram (Figure 19c) from which either the said input variable (X1) of the said one order is omitted or from which the said input variable (X2) of the said lower order is omitted.

## Patentansprüche

1. Optimierungsverfahren für eine logische Schaltung, um eine vielstufige logische Schaltung zu optimieren, die Gatter (A bis E) und Zwischengatterverbindungen aufweist und die betrieben werden kann, um eine Vielzahl von Eingangsvariablen (X1, X2) zu empfangen und eine Ausgangsvariable mit vorbestimmten logischen Werten (0, 1, 1, 0) im Ansprechen auf vorbestimmte eingangsvariable logische Werte oder vorbestimmte Kombinationen von eingangsvariablen logischen Werten (X1:0,0,1,1; X2:0,1,0,1) zu erzeugen, bei welchem Verfahren ein binäres Entscheidungsdiagramm erzeugt wird, um eine Funktion einer Ergebnisvariablen, die an einem spezifizierten Gatter (z.B. C) oder einem Anschluß der Schaltung erzeugt wurde, wiederzugeben, welche Funktion dazu dient, logische Werte (0, 1, 0) der Ergebnisvariablen im Ansprechen auf solche vorbestimmten eingangsvariablen logischen Werte oder solche vorbestimmten Kombinationen der eingangsvariablen logischen Werte (X1: 0,0,1,1; X2:0,1,0,1) zuzuordnen und bei welchem Verfahren das erzeugte Diagramm verarbeitet wird, um verkleinernde redundante Teile der Schaltung zu entfernen, und zwar ohne Beeinflussung der ausgangsvariablen logischen Werte, die durch die Schaltung erzeugt wurden, wobei das binäre Entscheidungsdiagramm durch die folgenden Schritte erzeugt wird:

Bestimmen einer Ordnung (X1, X2) der Eingangsvariablen;
Zuordnen der Eingangsvariablen (X1) erster Ordnung zu einer Wurzel des Diagramms, Zuordnen der Eingangsvariablen (X2) niederer Ordnung, wenn vorhanden, zu Knotenpunkten des Diagramms, und Zuordnen der unterschiedlichen zugeordneten logischen Werte (0, 1) zu jeweiligen Blättern (0, 1) des Diagramms; und
Verketten von Verzweigungen in sequentieller Weise von der Wurzel zu den Blättern hin über die Knotenpunkte, wenn vorhanden, um eine Baumstruktur zu bilden, wobei die Wurzel und jeder Knotenpunkt einen solchen Zweig besitzt, der sich von derselben für jeden logischen Wert (0, 1) aus erstreckt, den die Eingangsvariable (X1; X2), die der Wurzel des in Betracht stehenden Knotenpunktes zugeordnet ist, annehmen kann;

dadurch gekennzeichnet, daß das binäre Entscheidungsdiagramm eine zulässige Funktion der Ergebnisvariablen wiedergibt, in welcher ein kümmere-Dich-nicht-Wert (*) der Eingangsvariablen für irgendeinen solchen vorbestimmten eingangsvariablen logischen Wert oder einer vorbestimmten Kombination von eingangsvariablen logischen Werten (X1 = 0, X2 = 1) zugeordnet wird, wobei im Ansprechen darauf die Ergebnisvariable die Möglichkeit erhält, irgendeinen logischen Wert anzunehmen, ohne die ausgangsvariablen logischen Werte zu beeinflussen;

und daß während der Erzeugung des binären Entscheidungsdiagramms gemäß der zulässigen Funktion der kümmere-Dich-nicht-Wert (*) einem weiteren Blatt (*) des Diagramms zugeordnet wird.

2. Verfahren nach Anspruch 1, bei dem ein binäres Entscheidungsdiagramm gemäß der logischen Funktion auch erzeugt wird, um die logische Funktion solch einer Ergebnisvariablen wiederzugeben, wobei die logische Funktion dazu dient, zu der Ergebnisvariablen lediglich vorbestimmte logische Werte (0, 1) zuzuordnen und nicht dazu dient, dieser solch einen kümmere-Dich-nicht-Wert (*) zuzuordnen und bei dem das erzeugte binäre Entscheidungsdiagramm gemäß der logischen Funktion verarbeitet wird, um solch ein Beseitigen oder Verkleinern von redundanten Teilen der Schaltung zu bewirken, wobei das binäre Entscheidungsdiagramm gemäß der logischen Funktion durch die folgenden Schritte erzeugt wird:

Bestimmen einer Ordnung (X1, X2) der Eingangsvariablen;

Zuordnen der Eingangsvariablen (X1) erster Ordnung zu einer Wurzel des Diagramms, Zuordnen der Eingangsvariablen (X2) niedrigerer Ordnung, wenn vorhanden, zu Knotenpunkten des Diagramms, und Zuordnen von unterschiedlichen logischen Werten (0, 1), die durch die logische Funktion zugeordnet werden, zu jeweiligen Blättern (0, 1) des Diagramms; und Verketten von Verzweigungen in sequentieller Form von der Wurzel zu den Blättern hin über die Knotenpunkte, wenn vorhanden, um eine Baumstruktur zu bilden, wobei die Wurzel und jeder Knotenpunkt solch eine Verzweigung haben, die sich von derselben für jeden logischen Wert (0, 1) aus erstreckt, den die Eingangsvariable (X1; X2), die der Wurzel oder dem in Betracht stehenden Knotenpunkt zugeordnet ist, einnehmen kann.

3. Verfahren nach Anspruch 2, mit den folgenden Schritten:

(a) Bestimmen der Ordnung der Eingangsvariablen (X1, X2) der vielstufigen logischen Schaltung (S20);
(b) Erzeugen solch eines binären Entscheidungsdiagramms gemäß einer logischen Funktion, welches Diagramm solch eine logische Funktion wiedergibt, und zwar für jedes der Gatter (A bis E) und Verbindung oder Anschließen der Schaltung (S21);
(c) Erzeugen solch eines binären Entscheidungsdiagramms gemäß einer zulässigen Funktion, welches Diagramm solch eine zulässige Funktion wiedergibt, für jedes Gatter und Verbindung oder Anschließen der Schaltung (S22);
(d) Optimieren der Schaltung durch einen Suchvorgang, um redundante Teile der Schaltung zu entfernen und um Gatter derselben zusammenzuführen, die die erzeugte logische Funktion und die binären Entscheidungsdiagramme gemäß der zulässigen Funktion verwenden (S23); und
(e) Bestimmen, ob eine Änderung in der Schaltung als ein Ergebnis der Optimierung bei dem Schritt (d) (S24) durchgeführt worden ist oder nicht; und

Wiederholen der Schritte (b) bis (e), wenn bei dem Schritt (e) bestimmt wird, daß solch eine Änderung durchgeführt wurde, und Beenden der Verarbeitung, wenn bei dem Schritt (e) bestimmt wurde, daß keine solche Änderung in der Schaltung vorgenommen worden ist.

4. Verfahren nach Anspruch 3, bei dem der Schritt (b) (S21) die folgenden Schritte umfaßt:

(b1) Erzeugen solch eines binären Entscheidungsdiagramms gemäß einer logischen Funktion für jede der Eingangsvariablen (X1, X2) (S25);
(b2) Auswählen eines Gatters (z.B. A) aus den Gattern (A bis E) der vielstufigen logischen Schaltung, für welches die binären Entscheidungsdiagramme gemäß der logischen Funktion bereits für jedes Fan-in des Gatters (S26) erzeugt worden sind;
(b3) Erzeugen solch eines binären Entscheidungsdiagramms gemäß einer logischen Funktion für die Ausgangsgröße des ausgewählten Gatters (A) (S27);
(b4) Bestimmen, ob ein nicht berechnetes Gatter (B, C) vorhanden ist oder nicht, wobei es sich um ein Gatter handelt, für welches ein solches binäres Entscheidungsdiagramm gemäß einer logischen Funktion für die Gatterausgangsgröße noch nicht erzeugt worden ist (S28); und

Wiederholen der Schritte (b2) bis (b4) (S26 bis S28), wenn bei dem Schritt (b4) bestimmt wird, daß solch ein nicht berechnetes Gatter vorhanden ist, und Beendigen der Verarbeitung, wenn bei dem Schritt (b4) bestimmt wurde, daß solch ein nicht berechnetes Gatter nicht vorhanden ist.

5. Verfahren nach Anspruch 3 oder 4, bei dem der Schritt (c) die folgenden Schritte umfaßt:

(c1) Erzeugen solch eines binären Entscheidungsdiagramms gemäß einer zulässigen Funktion für die Ausgangsvariable (E) der vielstufigen logischen Schaltung (S29);
(c2) Wählen eines Gatters (z.B. E) für dessen Ausgangsgröße solch ein binäres Entscheidungsdiagramm gemäß einer zulässigen Funktion bereits erzeugt worden ist (S30);
(c3) Erzeugen jeweiliger binärer Entscheidungsdiagramme entsprechend einer zulässigen Funktion für Verbindungen (C→E, D→E), die Fan-ins des Gatters (E) sind, welches bei dem Schritt (c2) (S31) ausgewählt wurde;

(c4) Erzeugen jeweiliger solcher binärer Entscheidungsdiagramme gemäß einer zulässigen Funktion für Ausgangsgrößen der Gatter (C, D), die Eingangsgrößen für die Fan-in-Verbindungen oder Anschlüsse (C→E, D→E) für das ausgewählte Gatter (E) des Schrittes (c2) basierend auf den erzeugten binären Entscheidungsdiagrammen entsprechend einer zulässigen Funktion für solche Fan-in-Verbindungen oder Anschlüsse (S32) vorsehen;

(c5) Bestimmen, ob ein nicht berechnetes Gatter (A, B) vorhanden ist oder nicht, welches aus einem Gatter besteht, für welches ein solches binäres Entscheidungsdiagramm entsprechend einer zulässigen Funktion noch nicht erzeugt worden ist (S33); und

Wiederholen der Schritte (c2) bis (c5), wenn bei dem Schritt (c5) bestimmt wurde, daß solch ein nicht berechnetes Gatter vorhanden ist, und Beendigen der Verarbeitung, wenn bei dem Schritt (c5) bestimmt wurde, daß kein solches unberechnetes Gatter vorhanden ist (S33).

6. Verfahren nach irgendeinem der vorhergehenden Ansprüche, bei dem eine Kreuzungsoperation (Fig. 13) zwischen jeweiligen solchen binären Entscheidungsdiagrammen entsprechend einer zulässigen Funktion für die Ausgangsgröße von zwei Gattern (A, B) durch Versuchen, einen Zweig zu ändern, ausgeführt wird, welche solch eine vorbestimmte Kombination von eingangsvariablen logischen Werten wiedergeben, die laufend oder momentan mit dem weiteren Blatt (*) verkettet werden, so daß der Zweig stattdessen an einem der Blätter (0, 1) endet, zu welchem einer der unterschiedlich zugeordneten logischen Werte (0, 1) zugeordnet ist, wodurch ein weiteres binäres Entscheidungsdiagramm gemäß einer zulässigen Funktion für ein Gatter erzeugt wird, in welches die zwei Gatter (A, B) zusammengeführt werden.

7. Verfahren nach irgendeinem der vorhergehenden Ansprüche, bei dem, um eine neue logische Funktion oder ein binäres Entscheidungsdiagramm gemäß einer zulässigen Funktion für die Ausgangsgröße eines ausgewählten Gatters (E) zu erzeugen, welches betreibbar ist, um eine vorbestimmte logische Operation (z.B. ODER) auszuführen, basierend auf zwei existierenden logischen Funktion oder zwei existierenden Entscheidungsdiagrammen gemäß einer zulässigen Funktion, die jeweils zu den Ausgangsgrößen der zwei weiteren Gatter (C, D) bezogen sind, die als Fan-ins des ausgewählten Gatters (E) dienen, für jeden der vorbestimmten eingangsvariablen logischen Werte oder vorbestimmten Kombinationen von eingangsvariablen logischen Werte (X1 = 0, X2 = 0) die genannten zwei existierenden binären Entscheidungsdiagramme von deren jeweiligen Ursprung (X1) entlang wechselseitig entsprechender Zweige verfolgt werden, um das geeignete Blatt (Blatt 0 des C-Diagramms, Blatt 0 des D-Diagramms in Fig. 15b) von jedem Diagramm zu erreichen, wobei die vorbestimmte logische Operation (ODER) an den logischen Werten (0, 0) durchgeführt wird, die den Blättern zugeordnet sind, welche jeweils an den zwei existierenden binären Entscheidungsdiagrammen erreicht wurden, um den logischen Wert (0) zu bestimmen, der zu einem Blatt des neuen binären Entscheidungsdiagramms für den vorbestimmten eingangsvariablen logischen Wert oder die vorbestimmte Kombination der in Betracht stehenden eingangsvariablen Werte (0, 0) zuzuordnen ist.

8. Verfahren nach irgendeinem der vorhergehenden Ansprüche, bei dem in solch einem binären Entscheidungsdiagramm gemäß einer zulässigen Funktion (Fig. 18) die Wurzel und die Knotenpunkte, anders als die Blätter, in vier Nicht-Anschlußpunkt-Gruppen klassifiziert werden, die aus einer Gruppe "nicht 1", deren Mitglieder niemals mit einem Blatt verkettet werden, welches dem logischen Wert 1 zugeordnet ist, eine Gruppe "nicht 0", deren Mitglieder niemals mit einem Blatt verkettet werden, welches dem logischen Wert 0 zugeordnet ist, einer Gruppe "nicht d", deren Mitglieder niemals mit dem weiteren genannten Blatt verkettet werden, und eine Gruppe "andere" bestehen, wodurch die operationsmäßige Verarbeitung zwischen zwei solchen binären Entscheidungsdiagrammen beschleunigt wird.

9. Verfahren nach irgendeinem der vorhergehenden Ansprüche, bei dem eine zulässige Funktion oder ein binäres Entscheidungsdiagramm gemäß einer logischen Funktion (Fig. 19a) in ein anderes binäres Entscheidungsdiagramm (Fig. 19b) transformiert wird, indem als ein Knotenpunkt (45) irgendwelche zwei oder mehrere Knotenpunkte (40, 41) kombiniert oder zusammengeführt werden, die gemeinsam der Eingangsvariablen (X2) der niedrigsten Ordnung in dem zu transformierenden Diagramm zugeordnet sind, die mit dem gleichen Satz von Blättern (42, 43) durch die entsprechenden Sätze von Verzweigungen verkettet sind.

10. Verfahren nach irgendeinem der vorhergehenden Ansprüche, bei dem in solch einer zulässigen Funktion oder einem binären Entscheidungsdiagramm gemäß einer logischen Funktion dann, wenn die Wurzel (44) oder ein Knotenpunkt, der einer Eingangsvariablen (X1) von einer Ordnung zugeordnet ist, eine Verzweigung zu dem gleichen Knotenpunkt (45) erfolgt, der aus einem Knotenpunkt besteht, welcher einer Eingangsvariablen (X2) der niedrigeren Ordnung als die genannte eine Ordnung zugeordnet ist, oder zu dem gleichen Blatt verzweigt, und zwar für jeden logischen Wert (1, 0), welchen die Eingangsvariable (X1) der genannten einen Ordnung annehmen kann, wobei das binäre Entscheidungsdiagramm in ein binäres Entscheidungsdiagramm (Fig. 19c) transformiert wird, von welchem entweder die genannte Eingangsvariable (X1) der genannten einen Ordnung weggelassen wird oder von welchem die genannte Eingangsvariable (X2) der niedrigeren Ordnung weggelassen wird.

## Revendications

1. Procédé d'optimisation d'un circuit logique, destiné à optimiser un circuit logique à étages multiples qui comporte des portes (A à E) et des connexions entre les portes et peut être mis en oeuvre pour recevoir une pluralité de variables d'entrée (X1, X2) et pour produire une variable de sortie présentant des valeurs logiques prédéterminées (0, 1, 1, 0) en réponse à des valeurs logiques de variables d'entrée prédéterminées ou des combinaisons prédéterminées des valeurs logiques des variables d'entrée (X1 : 0, 0, 1, 1 ; X2 : 0, 1, 0, 1), dans lequel procédé, un diagramme de décision binaire est créé pour représenter une fonction d'une variable de résultat produite au niveau d'une porte spécifiée (par exemple C), ou d'une connexion du circuit, laquelle fonction sert à affecter des valeurs logiques (0, 0, 1, 0) à la variable du résultat en réponse à de telles valeurs logiques des variables d'entrée prédéterminées ou à de telles combinaisons prédéterminées des valeurs logiques des variables d'entrée (X1 : 0, 0, 1, 1 ; X2 : 0, 1, 0, 1), et le diagramme créé est traité pour éliminer ou diminuer les parties redondantes du circuit sans affecter les valeurs logiques des variables de sortie produites par le circuit, le diagramme de décision binaire étant créé grâce aux étapes consistant à:

déterminer un ordre (X1, X2) desdites variables d'entrée,
allouer la variable d'entrée du premier ordre (X1) à une racine du diagramme, allouer les variables d'entrée d'ordre inférieur (X2), s'il y en a, aux noeuds du diagramme, et allouer les différentes valeurs logiques affectées (0, 1) à des feuilles respectives (0, 1) du diagramme, et
relier des branches séquentiellement depuis ladite racine vers lesdites feuilles par l'intermédiaire desdits noeuds, s'il y en a, afin de former une structure arborescente, la racine et chaque noeud comportant une telle branche qui s'étend depuis celui-ci pour chaque valeur logique (0, 1) que peut prendre la variable d'entrée (X1, X2) allouée à la racine ou au noeud concerné,

caractérisé en ce que ledit diagramme de décision binaire représente une fonction autorisable de ladite variable de résultat, dans lequel une valeur indifférente (*) est affectée à la variable du résultat pour toute telle valeur logique de variable d'entrée prédéterminée ou combinaison prédéterminé des valeurs logiques des variables d'entrée (X1 = 0, X2 = 1) en réponse à laquelle, la variable du résultat peut prendre toute valeur logique sans affecter lesdites valeurs logiques des variables de sortie,

et en ce que, durant la création du diagramme de décision binaire de la fonction autorisable, ladite valeur indifférente (*) est allouée à une autre feuille (*) du diagramme.

2. Procédé selon la revendication 1, dans lequel un diagramme de décision binaire de fonction logique est également créé pour représenter la fonction logique d'une telle variable de résultat, laquelle fonction logique sert à affecter à cette variable de résultat uniquement des valeurs logiques prédéterminées (0, 1) et ne sert pas à affecter à celles-ci une telle valeur indifférente (*), et le diagramme de décision binaire de la fonction logique créé est traité pour réaliser une telle suppression ou réduction des parties redondantes du circuit, ledit diagramme de décision binaire de la fonction logique étant créé grâce aux étapes consistant à :

déterminer un ordre (X1, X2) desdites variables d'entrée,
allouer la variable d'entrée du premier ordre (X1) à une racine du diagramme, allouer des variables d'entrée d'ordre inférieur (X2), s'il y en a, à des noeuds du diagramme, et allouer les différentes valeurs logiques (0, 1) affectées par ladite fonction logique à des feuilles respectives (0, 1) du diagramme, et
relier des branches séquentiellement depuis ladite racine vers lesdites feuilles par l'intermédiaire desdits noeuds, s'il y en a, afin d'élaborer une structure arborescente, la racine et chaque noeud comportant une telle branche s'étendant depuis celui-ci pour chaque valeur logique (0, 1) que peut prendre la variable d'entrée (X1, X2) allouée à la racine ou au noeud concerné.

3. Procédé selon la revendication 2, comprenant les étapes consistant à :

(a) déterminer l'ordre desdites variables d'entrée (X1, X2) dudit circuit logique à étages multiples (S20),

(b) créer un tel diagramme de décision binaire de fonction de logique, représentant une telle fonction logique, pour chaque dite porte (A à E) et connexion dudit circuit (S21),

(c) créer un tel diagramme de décision binaire de fonction autorisable, représentant une fonction autorisable, pour chaque dite porte et connexion dudit circuit (S22),

(d) optimiser le circuit en cherchant à éliminer lesdites parties redondantes dudit circuit et à fusionner des portes de celui-ci en utilisant la fonction logique créée et les diagrammes de décision binaire des fonctions autorisables (S23), et

(e) déterminer si un changement a été apporté ou non audit circuit à la suite de l'optimisation de l'étape (d) (S24), et

répéter les étapes (b) à (e) s'il est déterminé à l'étape (e) qu'un tel changement a été apporté et mettre fin au traitement s'il est déterminé à l'étape (e) qu'aucun tel changement n'a été apporté audit circuit.

4. Procédé selon la revendication 3, dans lequel ladite étape (b) (S21) comprend les étapes consistant à :

(b1) créer un tel diagramme de décision binaire de fonction logique pour chaque dite variable d'entrée (X1, X2) (S25),

(b2) choisir, parmi lesdites portes (A à E) du circuit logique à étages multiples, une première porte (par exemple A) pour laquelle de tels diagrammes de décision binaire de fonction logique ont déjà été créés pour chaque entrance de la porte (S26),

(b3) créer un tel diagramme de décision binaire de fonction logique pour la sortie de la porte choisie (A) (S27),

(b4) déterminer s'il existe une porte non calculée ou non (B, C), qui est une porte pour laquelle aucun tel diagramme de décision binaire de fonction logique pour la sortie de la porte n'a encore été créé (S28), et

répéter les étapes (b2) à (b4) (S26 à S28) s'il est déterminé à l'étape (b4) qu'il existe une telle porte non calculée et mettre fin au traitement s'il est déterminé à l'étape (b4) qu'il n'existe aucune telle porte non calculée.

5. Procédé selon la revendication 3 ou 4, dans lequel ladite étape (c) comprend les étapes consistant à :

(c1) créer un tel diagramme de décision binaire de fonction autorisable pour ladite variable de sortie (E) dudit circuit logique à étages multiples (S29),

(c2) choisir une porte (par exemple E) pour la sortie de laquelle, un tel diagramme de décision binaire de fonction à déjà été créé (S30),

(c3) créer des diagrammes de décision binaire de fonctions autorisables respectives pour des connexions (C → E, D → E) qui sont les entrances de la porte (E) choisies à l'étape (c2) (S31),

(c4) créer des diagrammes de décision binaire de fonctions autorisables pour les sorties des portes (C, D) fournissant des entrées aux connexions des entrances (C → E, D → E) pour la porte choisie (E) de l'étape (c2) sur la base des diagrammes de décision binaire des fonctions autorisables créés pour ces connexions d'entrance (S32),

(c5) déterminer s'il existe ou non une porte non calculée (A, B), qui est une porte pour laquelle aucun tel diagramme de décision binaire de fonction autorisable n'a encore été créé (S33), et

répéter les étapes (c2) à (c5) s'il est déterminé à l'étape (c5) qu'il existe une telle porte non calculée et mettre fin au traitement s'il est déterminé à l'étape (c5) qu'il n'existe aucune telle porte non calculée (S33).

6. Procédé selon l'une quelconque des revendications précédentes, dans lequel une opération d'intersection (figure 13) est exécutée entre des diagrammes de décision binaire de fonctions autorisables pour les sorties des deux portes (A, B) en tentant de modifier une branche, représentant une telle combinaison prédéterminée des valeurs logiques des variables d'entrée, qui est actuellement reliée à ladite autre feuille (*) de sorte que la branche aboutisse à la place au niveau de l'une desdites feuilles (0, 1) auxquelles l'une desdites valeurs logiques affectées différentes (0, 1) est allouée, en créant ainsi un autre diagramme de décision binaire de fonction autorisable pour une porte en laquelle lesdites deux portes (A, B) sont fusionnées.

7. Procédé selon l'une quelconque des revendications précédentes, dans lequel, pour pouvoir créer un nouveau diagramme de décision binaire de fonction logique ou de fonction autorisable pour la sortie d'une porte sélectionnée (E) qui peut être mis en oeuvre pour exécuter une opération logique prédéterminée (par exemple OU), sur la base de deux fonctions logiques existantes ou de deux diagrammes de décision binaire de fonctions autorisables existants se rapportant respectivement aux sorties de deux autres portes (C, D) servant d'entrances de ladite porte sélectionnée (E), pour chacune à son tour desdites valeurs logiques des variables d'entrée prédéterminées ou des combinaisons prédéterminées des valeurs logiques des variables d'entrée (par exemple X1 = 0, X2 = 0), les deux dits diagrammes de décision binaire existants sont tracés à partir de leurs racines respectives (X1) le long de branches mutuellement correspondantes afin d'atteindre la feuille appropriée (feuille 0 du diagramme C, feuille 0 du diagramme D sur la figure 15b) de chaque diagramme, ladite opération logique prédéterminée (OU) est exécutée sur les valeurs logiques (0, 0) allouées aux feuilles atteintes respectivement sur les deux diagrammes de décision binaire existants de façon à déterminer la valeur logique (0) devant être allouée à une feuille dudit nouveau diagramme de décision binaire pour la valeur logique de variable d'entrée prédéterminée ou la combinaison prédéterminée des valeurs logiques des variables d'entrée concernées (0, 0).

**8.** Procédé selon l'une quelconque des revendications précédentes, dans lequel, dans un tel diagramme de décision binaire de fonction autorisable (figure 18), la racine et les noeuds autres que les feuilles sont classés en quatre groupes de points non terminaux constitués du groupe "non 1" dont les éléments ne sont jamais reliés à une feuille allouée à la valeur logique 1, un groupe "non 0", dont les éléments ne sont jamais reliés à une feuille allouée à la valeur logique 0, un groupe "non d" dont les éléments ne sont jamais reliés à ladite autre feuille, et des groupes "autres", en accélérant ainsi le traitement fonctionnel entre deux tels diagrammes de décision binaire.

**9.** Procédé selon l'une quelconque des revendications précédentes, dans lequel un tel diagramme de décision binaire d'une fonction autorisable ou d'une fonction logique (figure 19a) est transformé en un autre diagramme de décision binaire (figure 19b) en combinant, sous forme d'un seul noeud (45) deux ou plusieurs noeuds quelconques (40, 41) alloués en commun à la variable d'entrée (X2) de l'ordre le plus bas du diagramme à transformer, qui sont reliés au même ensemble de feuilles (42, 43) par des ensembles correspondants de branches.

**10.** Procédé selon l'une quelconque des revendications précédentes, dans lequel dans un tel diagramme de décision binaire de fonction autorisable ou de fonction logique, lorsque la racine (44), ou un noeud alloué à une variable d'entrée (X1) d'un premier ordre, est branché sur le même noeud (45), qui est un noeud alloué à une variable d'entrée (X2) d'ordre inférieur audit premier ordre, ou est branché sur la même feuille, pour chaque valeur logique (1, 0) que peut prendre la variable d'entrée (X1) dudit premier ordre, le diagramme de décision binaire est transformé en un diagramme de décision binaire (figure 19c) à partir duquel, soit ladite variable d'entrée (X1) dudit premier ordre est omise, soit à partir duquel ladite variable d'entrée (X2) dudit ordre inférieur est omise.

MULTISTAGE NETWORK OF LOGICAL EXPRESSION

TWO-STAGE SUM-OF-PRODUCTS LOGICAL EXPRESSION

f=ab + acd + e

TRUTH TABLE

TECHNOLOGY-INDEPENDENT SYNTHESIS

MULTISTAGE NETWORK OF LOGICAL EXPRESSION

TECHNOLOGY-DEPENDENT SYNTHESIS

NET LIST OF GATE CELLS

Fig. 1

Fig. 2

$$f = ab + b\bar{c} + \overline{ac} \longrightarrow f = ab + \overline{ac}$$

Fig. 3 (a)

$$f = abc + abd + \overline{a}\overline{c}\overline{d} + \overline{b}\overline{c}\overline{d} \longrightarrow f = xy + \overline{x}\overline{y}$$
$$x = ab$$
$$y = c + d$$

Fig. 3 (b)

EP 0 413 831 B1

THE VALUE OF NODE j IS ALWAYS
THE NEGATION OF g. THUS, COMBINATIONS
OF j=0 AND g=0, OR j=1 AND g=1 DO NOT EXIST

FOR ALL NODES $D=gj+\bar{g}\bar{j}$ IS ADDED AS
ONE OF DON'T-CARE CONDITIONS.

SINCE j=0 WHEN g=1, THE VALUE OF h IS 0
INDEPENDENTLY OF f. THAT IS, THE VALUE OF
f WHEN g=1 HAS NO INFLUENCE ON THE OUTSIDE.

FOR NODE OF f
D=g IS ADDED AS A DON'T-CARE CONDITION.

*Fig. 4*

EP 0 413 831 B1

$f_1=[0,0,1,1]$

V1

V2

$f_2=[0,1,0,1]$

v3 = v1 · v2

8

$f_3=[0,0,0,1]$

$f'_3=[0,0,*,*]$

V3

9

v4 = v1 + v3

V4

V5

$f_5=[0,0,1,1]$

Fig. 5

EP 0 413 831 B1

[0,0,1,1]

[0,0,1,0]

[0,1,1,0]

[0,1,0,0]

[0,1,0,1]

*Fig.6(a)*

(0,\*,1,\*)

(0,\*,1,0)

(\*,\*,1,0)

(0,1,1,0)

(\*,1,\*,0)

(0,1,\*,0)

(0,1,\*,\*)

*Fig.6(b)*

21

Fig. 6 (c)

Fig. 6 (d)

Fig . 6 (f)

Fig. 6 (g)

Fig. 6 (e)

Fig. 7(a)

Fig. 7 (b)

Fig. 7(c)

Fig. 7(e)

Fig. 7(d)

Fig. 8

Fig. 9

Fig. 10

START

CREATE GRAPHS OF LOGIC FUNCTION OF INPUT VARIABLES — S25

CHOOSE ONE GATE IN WHICH LOGIC FUNCTION OF FAN-INS HAVE BEEN CALCULATED — S26

CREATE GRAPH OF LOGIC OF FUNCTION GATE FROM FAN-INS GRAPHS OF LOGIC FUNCTIONS — S27

IS THERE UNCALCULATED GATE ? — S28     YES

NO

END

Fig. 11

START

S29

CREATE GRAPH OF PERMISSIBLE FUNCTION
OF OUTPUT VARIABLE

S30

CHOOSE ONE GATE WHOSE PERMISSIBLE
FUNCTION HAS BEEN CALCULATED

S31

CREATE GRAPHS OF PERMISSIBLE FUNCTIONS
OF NETS SERVING AS FAN-INS OF GATE

S32

CREATE GRAPH OF PERMISSIBLE FUNCTION OF
GATE  SERVING AS INPUT OF NET FROM ITS
PERMISSIBLE FUNCTION

S33    YES

IS THERE UNCALCULATED GATE
?

NO

E N D

Fig. 12

PERMISSIBLE
FUNCTION OF
GATE A

PERMISSIBLE
FUNCTION OF
GATE B

Fig. 13

Fig. 14

LOGIC OF GATE C          LOGIC OF GATE D          CREATED LOGIC OF GATE E

Fig. 15 (a)

EP 0 413 831 B1

Fig . 15 (b)

Fig.15(c)

Fig. 15 (d)

Fig. 15 (e)

Fig. 15 (f)

EP 0 413 831 B1

Fig. 15 (g)

Fig. 15 (h)

Fig. 15 (i)

EP 0 413 831 B1

Fig. 15(j)

```
gate_merging()
{
    foreach gate g1 {
        foreach gate g2(≠g1) {
            stat = try_merge(g1,g2);
            if (stat == TRUE && merit > 0) {
                change_circuit();
                recalculate_logic();
                recalculate_CSPF();
            }
        }
    }
}

Bool try_merge(g1, g2)
{
    pf = PF(g1) ∩ PF(g2);
    /* PF means Permissible Function */
    if (pf == NULL) {
        return FALSE;
    }
    /* now try to make new gate
       whose logic is contained by pf */
    foreach gate g in candidates {
        try to connect g to new gate;
    }
    try to delete fanins from new gate;
    if (pf contains new gate's logic) {
        return TRUE;
    }
    return FALSE;
}
```

## Fig. 16

```
apply(v1, v2, op)
{
    clear T[];
    v = apply_step(v1, v2, op);
    return v;
}

apply_step(v1, v2, op)
{
    val = v1->val op v2->val;
    if (val is terminal node's value) {
        return newVertex2(val);
    }
    new = T[v1->id, v2->id];
    if (new ≠ NULL) {
        return new;
    }
    index = min(v1->index, v2->index);
    if (index == v1->index) {
        v1_low = v1->low;
        v1_high = v1->high;
    } else {
        v1_low = v1_high = v1;
    }
    if (index == v2->index) {
        v2_low = v2->low;
        v2_high = v2->high;
    } else {
        v2_low = v2_high = v2;
    }
    low = apply_step(v1_low, v2_low, op);
    high = apply_step(v1_high, v2_high, op);
    new = newVertex(low, high, index);
    T[v1->id, v2->id] = new;
    return new;
}

newVertex(low, high, index)
{
    if (v exists such that
        v->low == low && v->high == high
     && v->index == index) {
        return v;
    }
    make new node v;
    v->low = low;
    v->high = high;
    v->index = index;
    return v;
}

newVertex2(val)
{
    if (v exists such that v->val == val) {
        return v;
    }
    make new node v;
    v->val = val;
    return v;
}
```

Fig. 17

45

Fig. 18

GROUP non _ 1

GROUP non _ 0

GROUP non _ d

GROUP others

EP 0 413 831 B1

ORIGINAL BINARY
DECISION GRAPH

*Fig. 19 (a)*

MERGING PROCESS

*Fig. 19 (b)*

REMOVING PROCESS

*Fig. 19 (c)*

EP 0 413 831 B1

Fig. 20 (a)

Fig. 20 (b)

Fig. 20 (c)

Fig. 20(d)

Fig. 20(f)

Fig. 20(e)

Fig. 21

⊕ DESIGNATES EXCLUSIVE – OR (a b̄ + ā b)

Fig. 22

EP 0 413 831 B1